# FASCICULE DE BREVET EUROPEEN

(11) **EP 2 802 711 B1**
(45) Date de publication et mention de la délivrance du brevet: **25.10.2017**
(21) Numéro de dépôt: 12818998.2
(22) Date de dépôt: 21.12.2012
(51) Int. Cl.: D21H 27/00, H05K 3/00, B32B 29/06, B41M 1/22, H05K 1/16, H05K 3/20, H05K 1/09, H05K 1/03

(54) **PROCÉDÉ DE FABRICATION D'UNE FEUILLE**
VERFAHREN ZUR HERSTELLUNG EINER FOLIE
METHOD FOR PRODUCING A SHEET

(30) Priorité: 13.01.2012 FR 1250366; 02.07.2012 FR 1256336
(43) Date de publication de la demande: 19.11.2014
(73) Titulaire: Arjo Wiggins Fine Papers Limited, Manchester M1 5ES (GB)
(72) Inventeur: DEPRES, Gaël, F-38850 Chirens (FR); VAU, Jean-Marie, F-75012 Paris (FR)
(74) Mandataire: Robert, Mathias
(86) Numéro de dépôt international: PCT/EP2012/076829
(87) Numéro de publication internationale: WO 2013/104520

(56) Documents cités:
- WO-A1-2007/070391
- WO-A2-2006/076613
- WO-A2-2008/070532
- US-A1- 2011 079 344

## Description

La présente invention concerne un procédé de fabrication d'une feuille électro-conductrice, cette feuille comportant un substrat, en particulier en papier, et une couche électro-conductrice. La présente invention concerne également un procédé de fabrication d'une feuille, dont une face comporte une zone de plus grand lissé que le reste de la face, cette zone comportant une couche externe lisse qui s'étend sur une surface inférieure à celle de la face précitée et qui est une couche électro-conductrice ou qui est destinée à être recouverte d'une couche électro-conductrice. Ces feuilles sont particulièrement appropriées, mais non exclusivement, pour être utilisées dans des applications en électronique, telles que par exemple en électronique imprimée (*Printed Electronic*).

On a déjà proposé de fabriquer une feuille pour l'électronique imprimée à partir d'un procédé comprenant les étapes consistant à préparer une structure multicouche comprenant un film plastique, une couche imprimable, et une couche antiadhésive intercalée entre le film plastique et la couche imprimable, à contrecoller la structure multicouche et le substrat, à retirer le film plastique de la couche imprimable, puis à imprimer cette couche imprimable avec une encre ayant des propriétés électriques.

Cependant, après sa fabrication, cette feuille n'est pas forcément électriquement conductrice car, bien qu'elle soit imprimée avec une encre comportant des particules électro-conductrices, ces particules ne sont pas interconnectées les unes aux autres de façon à former une couche continue électro-conductrice.

L'électronique imprimée consiste à déposer une couche électro-conductrice sur un support souple et flexible, tel qu'un film plastique, en vue de la fabrication de composants électroniques tels que des puces électroniques, du type RFID par exemple.

Cependant, bien que les films plastiques (tels que ceux en PEN et en PET) possèdent une faible rugosité de surface qui est particulièrement intéressante pour l'électronique imprimée, ces films plastiques sont peu stables thermiquement et relativement coûteux (le coût de ces films étant supérieur ou égal à 4 euros/m² environ).

L'invention a notamment pour but d'apporter une solution simple, efficace et économique aux problèmes et besoins de la technique antérieure et a pour objet un procédé de fabrication d'une feuille, en particulier à base d'un papier, et comportant une couche électro-conductrice.

Au contraire des films plastiques, les papiers et feuilles à base de papier sont plus économiques et ont en outre l'avantage de pouvoir être recyclables et d'être plus stables thermiquement. De plus, l'utilisation de feuilles ou de papiers pour l'électronique imprimée autorise la réalisation de très grandes surfaces imprimées, qui sont plus difficiles à obtenir à partir de films plastiques. Par ailleurs, une feuille ou un papier peut être imprimé pour une application en électronique directement après sa fabrication, c'est-à-dire que la machine d'impression peut être disposée directement après la machine de fabrication du papier, selon un process continu (*roll-to-roll process*). De plus, il est plus facile d'obtenir un papier blanc et brillant qu'un film plastique blanc et brillant car la combinaison des propriétés de blancheur et de brillance sont difficiles à obtenir avec un film plastique, lequel est d'ailleurs plus difficile à recouvrir avec une composition de couchage en milieu aqueux qu'un papier qui a une nature hydrophile.

L'invention propose à cet effet un procédé de fabrication d'une feuille comportant au moins une couche électro-conductrice, cette feuille comportant un substrat, en particulier en papier, dont au moins une face est recouverte au moins en partie d'une couche ou de plusieurs couches superposées dont la couche électro-conductrice précitée, le procédé comprenant les étapes consistant à :
a/ préparer ou apporter une structure multicouche comprenant au moins, ou constituée par, un film plastique, un revêtement antiadhésif, et une couche de base, le revêtement antiadhésif étant intercalé entre une face du film plastique et la couche de base,
b/ encoller une face du substrat et/ou la face de la structure multicouche située du côté opposé au film plastique, et appliquer la face précitée du substrat contre la face précitée de la structure multicouche, de façon à contrecoller la structure multicouche et le substrat,
c/ retirer le film plastique et le revêtement antiadhésif de la couche de base, caractérisé en ce que la couche de base est une couche d'un matériau électro-conducteur ou est recouverte d'une couche électro-conductrice par une étape supplémentaire consistant à :
   d1/ déposer un film électro-conducteur sur la couche de base ; ou
   d2/ imprimer la couche de base avec au moins une encre ayant des propriétés électriques, la couche de base étant une couche imprimable à base d'un liant dont le taux est supérieur à 15% en poids sec par rapport au poids total de matière sèche de cette couche, puis éventuellement soumettre la feuille imprimée à un traitement thermique de recuit de façon à former une couche d'encre électro-conductrice.

La couche de base peut être une couche optique et/ou optoélectronique formant par exemple un guide d'onde.

Dans la présente demande, on entend par feuille et par substrat destiné à la préparation de la feuille, un élément mince (dont l'épaisseur ne dépasse pas 1 mm, et par exemple 0,5mm), de préférence souple et/ou flexible.

Le procédé selon l'invention définit au moins trois modes de réalisation distincts alternatifs selon la nature de la couche de base de la feuille, pour préparer une feuille comportant les propriétés voulues.

La couche de base peut comprendre un matériau électro-conducteur ou être réalisée dans un matériau électro-conducteur et peut donc définir elle-même une couche électro-conductrice. La couche de base peut par exemple être formée d'une couche métallique.

En variante, la couche de base peut être destinée à être recouverte d'une couche électro-conductrice, et être ainsi recouverte d'une couche électro-conductrice qui est soit un film électro-conducteur soit une couche d'encre électro-conductrice. Dans ce dernier cas, la couche de base est une couche imprimable qui est imprimée avec une encre ayant des propriétés électriques et qui est ensuite éventuellement soumise à une étape de recuit de façon à former une couche continue d'encre électro-conductrice sur la couche de base. Une encre ayant des propriétés électriques est une encre comportant des éléments conducteurs tels que des nanoparticules et/ou des molécules, ces éléments conférant à un feuille imprimée avec l'encre (et éventuellement soumis à une étape de recuit) une conductivité électrique.

Les inventeurs ont constaté que ce dernier mode de réalisation permettait de produire une feuille avec une bonne conductivité électrique. Ce paramètre peut être déterminé par un appareil appelé « appareil 4 pointes ». La méthode de détermination de ce paramètre sera décrite plus en détail dans ce qui suit.

Les trois modes précités de réalisation de l'invention ont notamment en commun le fait de produire une feuille électro-conductrice, c'est-à-dire une feuille présentant une conductivité électrique suffisante en vue par exemple de son utilisation en électronique.

Dans ces modes de réalisation, la couche électro-conductrice peut être soumise à une étape supplémentaire d'ablation laser pour la réalisation d'un circuit électrique ou autre sur la feuille, selon des motifs particuliers.

Le procédé selon l'invention permet de réaliser une feuille ayant une couche électro-conductrice avec une couche de base lisse (ou faiblement rugueuse) et brillante. Le lissé obtenu est supérieur à celui d'une feuille ou d'un papier fabriqué par un procédé classique, et est suffisant pour utiliser la feuille dans le domaine de l'électronique. La rugosité (AFM) de la feuille obtenue par le procédé selon l'invention est par exemple de l'ordre de 10 nm.

De plus, lorsque cette couche de base est imprimable, on peut constater que, après impression, la densité optique des encres reste relativement constante au cours du temps. Plus la densité optique des encres sur la feuille augmente/varie et plus les encres pénètrent en profondeur dans la feuille et moins ces encres restent donc en surface de la feuille, ce qui signifie que la surface imprimée de la feuille est relativement poreuse (ou « ouverte ») par opposition à une surface non poreuse (ou « fermée ») d'une feuille sur laquelle les encres restent en surface.

Dans le cas de l'électronique imprimée, lorsque la couche de base est destinée à être imprimée avec une encre ayant des propriétés électriques, il est important que la couche de base soit la moins poreuse possible (c'est-à-dire la plus fermée possible) car la fraction des encres qui pénètre dans les pores de la feuille ne participe pas à la conduction. Pour cela, dans le cadre de l'invention, la couche de base imprimable comprend un taux de liant qui est supérieur à 15% en poids sec par rapport au poids total de matière sèche de cette couche. Le taux de liant peut être supérieur à 20% en poids sec par rapport au poids total de matière sèche de cette couche. Il est par exemple compris entre 15 et 100% et de préférence entre 20 et 100% en poids sec par rapport au poids total de matière sèche de cette couche. Il peut être compris entre 15 et 50% (ou entre 20 et 50%), de préférence entre 15 et 40% (ou entre 20 et 40%), et plus préférentiellement entre 15 et 30% (ou entre 20 et 30%), en poids sec par rapport au poids total de matière sèche de cette couche. Dans le cas où la couche de base comprend 100% en poids sec par rapport au poids total de matière sèche de cette couche, cette couche ne comprend pas de pigments.

Plusieurs types d'application pour l'électronique imprimée existent, dont six ressortent principalement :
- les circuits imprimés comportant des pistes conductrices, des résistances, des capacités et des transistors ;
- les cellules photovoltaïques ;
- les écrans (électrochromes ou LCD) ;
- les claviers à membrane ; la feuille peut alors comprendre un composant ou être soumise à un traitement particulier pour la rendre ignifuge, la feuille peut par exemple comprendre des retardateurs de flamme de type trihydroxyde d'aluminium, par exemple du BACO FRF40® de la société Alcan Chemicals (des valeurs de 30 % de BACO FRF40® dans la masse de la feuille peuvent permettre d'obtenir un classement au feu M1 ou M2) ; on peut aussi rajouter des produits en *size press,* de type sels de phosphore/ammonium avec des taux de 50 % par rapport à l'amidon ; d'autres produits peuvent également être utiliser, par exemple à base de polyphosphate d'ammonium, de trioxyde d'antimoine, de sulfamate d'ammonium, etc. ;
- les OLEDs (diodes électroluminescentes organiques) sont des diodes électroluminescentes dont le matériau émetteur est un matériau organique ; lorsque ce matériau est traversé par un courant, il devient source de lumière ;
- les membranes « Switch » (ou commutateur à membrane) permettent de faire une connexion momentanée par contact ; de l'encre conductrice est déposée sur un support flexible de type polyester ou polycarbonate ; un dôme se forme et constitue l'élément actif d'un bouton ; sous l'effet d'une pression, le dôme se déforme et ferme le circuit ; cette technologie est utilisée dans les téléphones portables, les appareils photos, les tableaux de commande, les jouets, etc. ; et
- les étiquettes RFID (*Radio Frequency IDentification*), également appelées étiquettes intelligentes ou étiquettes à puces ou tag ou transpondeur sont des équipements destinés à recevoir un signal radio et à renvoyer en réponse un signal radio différent, contenant une information.

L'homme du métier, spécialisé dans l'électronique imprimée, est à même de déterminer les différentes couches de la feuille ou de la structure multicouche précitée, qui sont nécessaires à la réalisation des composants électroniques du type précité, ainsi qu'aux dispositions respectives de ces couches dans la feuille obtenue par le procédé selon l'invention. Ces différentes couches peuvent être déposées sur la feuille selon l'invention par les mêmes techniques que celles employées dans la technique antérieure pour le dépôt de couches similaires sur des films plastiques pour l'électronique imprimée.

Les informations ci-dessous concernent essentiellement les étapes a) à c) du procédé selon l'invention.

La structure multicouche de la feuille peut être préparée préalablement à la mise en oeuvre du procédé de fabrication de la feuille imprimable. Dans ce cas, la structure multicouche est apportée pour la réalisation du procédé de fabrication de la feuille.

Selon l'invention, la couche de base est préparée sur un film plastique appelé « donneur », cette couche de base étant, à ce stade, comprise dans une structure multicouche, puis est transférée sur le substrat appelé « receveur ». Cette technique permet de transférer le lissé du film plastique à la couche de base dont le lissé ne dépend donc pas de celui du substrat utilisé. L'invention permet donc de transférer l'état de surface d'un film plastique sur un substrat quelconque. Autrement dit, l'invention permet de fabriquer une feuille relativement lisse à partir d'un substrat quelconque, tel qu'avantageusement un papier rugueux et/ou un papier ayant une main relativement importante, par exemple supérieure ou égale à 0,9 cm³/g, voire à 1,10 cm³/g, et sans inclure un film plastique dans la feuille ainsi réalisée. Le substrat peut également être un papier calque, un papier classique, un papier de faible grammage, un papier couché, un papier cartonné, un papier précouché, une feuille ou un film plastique, une feuille ou une lame de verre, une feuille de métal telle qu'une tôle, une lame de bois, un tissu, etc.

Dans la présente demande, on entend par feuille et par substrat destiné à la préparation de la feuille, un élément mince (dont l'épaisseur ne dépasse pas 500gm), de préférence souple et/ou flexible.

Une structure multicouche de l'invention préparée ou apportée dans le cadre du procédé selon l'invention comporte notamment, ou est constituée par, un film plastique inférieur, un revêtement intermédiaire antiadhésif et une couche de base supérieure. Le revêtement antiadhésif recouvre au moins une partie de la face supérieure du film plastique, et la couche de base recouvre au moins une partie de la face supérieure du revêtement antiadhésif.

Le film plastique sert de support de fabrication de la couche de base. Ce film ne subsiste pas dans le produit final, à savoir la feuille, qui peut donc être recyclable. La face supérieure du film (située du côté de la couche de base) est avantageusement la plus lisse possible, car la qualité de surface de la face lisse de la feuille, définie par la couche de base, est fonction de la qualité de surface de cette face supérieure du film plastique. Autrement dit, plus le film plastique de la structure multicouche est lisse et plus la feuille obtenue est lisse.

Le film plastique est choisi parmi un film de polyéthylène téréphtalate (PET), de polyéthylène (PE), de polypropylène (PP), de polymère à base d'acide polylactique (PLA), de tout polymère à base de cellulose, etc. Le film a par exemple une épaisseur de l'ordre de 12jj.m.

La face du film située du côté de la couche de base est de préférence lisse et peut avoir un lissé Bekk supérieur à 10 000s Bekk.

L'épaisseur, la dureté et la température de transition vitreuse du film plastique n'ont pas ou ont peu d'influence sur les caractéristiques de la couche de base. Seul(e) le lissé, ou a contrario, la rugosité du film plastique a une influence sur le lissé ou la rugosité de la couche de base. Plus le film plastique est lisse et plus la couche de base est lisse. L'homme du métier est toutefois à même de déterminer quelles caractéristiques du film plastique sont susceptibles d'influencer l'état de surface de la couche de base, et d'optimiser ces caractéristiques en fonction du lissé final que l'on souhaite obtenir pour cette couche de base.

Le revêtement antiadhésif de la structure multicouche est déposé sur le film plastique par une technique quelconque, et par exemple par héliogravure. Ce revêtement antiadhésif a pour fonction de limiter l'adhérence de la couche de base sur le film plastique et de faciliter la séparation et le retrait du film plastique de la couche de base à l'étape c/ du procédé ci-dessus défini. Le revêtement antiadhésif ne modifie pas ou peu le lissé et la qualité de surface de la face du film plastique, sur laquelle est déposée cette couche.

Le revêtement antiadhésif adhère de préférence plus sur le film plastique que sur la couche de base, de façon à ce que l'intégralité du revêtement reste collée sur le film plastique, lors de son retrait de la couche de base.

Le revêtement antiadhésif a une épaisseur inférieure ou égale à zum et de préférence à 1µm. Son épaisseur est de préférence supérieure à 0,1 ou 0,2µm. Le revêtement antiadhésif peut être composé de silicone(s), siloxane(s), polysiloxane(s) ou de ses dérivés, complexe(s) de Werner, tels que les stéaro chlorures de chrome, ou de cires de polyéthylène, de propylène, de polyuréthane, de polyamide, polytétrafluoroéthylène, d'un polymère acrylique, etc. Avantageusement, le revêtement antiadhésif de comprend pas de PVDF.

Comme indiqué dans ce qui précède, selon le mode de réalisation de l'invention, la couche de base peut être électro-conductrice ou non et peut être imprimable ou non.

De préférence, la couche de base est exempte d'agent anti-adhérent et/ou de produit susceptible de diminuer l'énergie de surface de la couche, tel qu'une matière siliconée ou analogue, du PVDF, du PP, du téflon, de la silice, du nitrure de bore, etc. Ce type d'agent ou produit peut être nécessaire pour une impression d'une couche par transfert thermique, en particulier pour éviter que le substrat n'adhère au ruban de l'imprimante. La couche de base selon l'invention peut donc ne pas être imprimable par transfert thermique.

La couche de base peut avoir une épaisseur inférieure ou égale à 30µm, de préférence inférieure ou égale à 15µm, et plus préférentiellement inférieure ou égale à 10µm. Son grammage est avantageusement inférieur ou égal à 30g/m², de préférence inférieur ou égal à 15g/m², et plus préférentiellement inférieur ou égal à 10g/m². La couche de base peut par exemple avoir une épaisseur et un grammage qui sont inférieurs ou égaux aux valeurs combinées suivantes : 10µm et 10g/m², 3µm et 10g/m², 2µm et 10g/m², 5µm et 5g/m², 3µm et 5g/m², 2µm et 5g/m², 5µm et 2g/m², 3µm et 2g/m², ou 2µm et 2g/m².

La couche de base peut être déposée sur le revêtement antiadhésif par une technique quelconque, et par exemple par héliogravure.

La couche de base peut être déposée sur le revêtement antiadhésif à l'état liquide ou semi-liquide puis être solidifiée par séchage, chauffage, ou par radiation UV ou électronique. Après solidification et/ou séchage, la couche de base, qui est en contact avec la face lisse du film plastique par l'intermédiaire du revêtement antiadhésif, présente une face lisse, située du côté du film plastique.

La couche de base est donc séchée et/ou solidifiée avant son transfert sur le substrat, en particulier pour ne pas modifier l'état de surface de cette couche conféré par le film plastique. Autrement dit, la structure multicouche est préparée préalablement au transfert de la couche de base sur le substrat, et la couche de base est à l'état solide et/ou sec pendant son transfert sur le substrat, c'est-à-dire aux étapes b/ et c/ du procédé selon l'invention. L'état de surface de la couche de base est donc créé pendant la préparation de la structure multicouche.

Dans le procédé selon l'invention, la fabrication de la couche de base est donc réalisée indépendamment de celle du substrat de base. Cela permet notamment de mettre en oeuvre le procédé avec des outils industriels standard, ce qui autorise des vitesses de production optimales.

La couche de base de la feuille peut avoir un lissé Bekk supérieur à 900 ou 1000s environ, de préférence supérieur à 2000s, et plus préférentiellement supérieur à 5000s.

Cette couche de base peut avoir une brillance supérieure à 70 %, et de préférence supérieure à 80%, cette brillance étant par exemple mesurée à 75 selon la méthode TAPPI® T480 om-92. Cette brillance peut être similaire voire supérieure à celle d'un papier photographique du type *resin-coated,* comportant un film plastique.

La structure multicouche peut comprendre au moins une couche supplémentaire déposée sur la couche de base, du côté opposé au film plastique, la face libre de cette couche supplémentaire ou de la couche supplémentaire la plus éloignée du film plastique étant destinée, à l'étape b/, à être encollée et appliquée contre la face précitée du substrat.

La ou les couches supplémentaires peuvent être fonctionnelles ou non fonctionnelles. Elles peuvent par exemple être isolantes (diélectriques) ou former une barrière (aux gaz, par exemple à l'oxygène, aux liquides, par exemple à l'eau, aux graisses, etc.).

La feuille peut comprendre un film métallique et/ou une couche barrière à base de polyuréthane (PU), de polyalcool vinylique (PVA), de polychlorure de vinylidène (PVDC), de copolymère éthylène-acétate de vinyle (EVAC), de nanofibres de cellulose, ou de métal, cette couche barrière étant située entre le substrat et la couche de base. Une couche à base de PVA est particulièrement adaptée pour former une barrière contre les gaz et une couche à base de PU est particulièrement adaptée pour former une barrière contre la vapeur d'eau.

La couche électro-conductrice peut faire office de couche barrière, cette couche électro-conductrice formant la couche externe de la feuille ou au contraire étant prise en sandwich entre deux couches de la feuille. La couche électro-conductrice peut être une couche métallique déposée sous vide ou un film de métal (tel qu'en aluminium par exemple), qui peut être rapporté et fixé par contrecollage.

La ou chaque couche supplémentaire peut être une couche d'un matériau semi-conducteur (P3HT - poly-3-hexylthiophène, etc.) dopé N, P ou non dopé, une couche d'un matériau diélectrique (PVP, etc.), une couche métallique (or, argent, aluminium, etc.), une couche de polymère électro-conducteur (PEDOT:PSS - poly(3,4-éthylènedioxithiophène : poly(styrènesulfonate), etc.).

Dans le cas où la structure multicouche comprend une seule couche supplémentaire, celle-ci peut être déposée soit sur la face supérieure de la couche de base, c'est-à-dire sur la face de la couche de base, située du côté opposé au film plastique de la structure multicouche, soit sous la couche de base.

Cette couche supplémentaire peut être de n'importe quelle nature. Dans le cas où la structure multicouche comprend deux ou plusieurs couches supplémentaires, ces couches supplémentaires sont superposées les unes sur les autres et déposées sur la face supérieure précitée de la couche de base. La ou les techniques employées pour déposer la ou les couches supplémentaires sur la couche de base peuvent être des types précités, ou de tout autre type.

La structure multicouche peut donc comprendre en plus des trois éléments précités (un film plastique, un revêtement antiadhésif, et une couche de base), une ou plusieurs couches supplémentaires sur la couche de base. La structure multicouche peut en outre comprendre une couche ou un film de colle recouvrant la couche la plus éloignée du film plastique (c'est-à-dire la couche de base ou la ou une couche supplémentaire).

L'étape b/ du procédé selon l'invention consiste à encoller la face du substrat destinée à recevoir la couche de base, ou la face de la structure multicouche, située du côté opposé au film plastique, et à appliquer ces faces l'une contre l'autre, de façon à les fixer.

Le substrat peut être choisi parmi un papier, un papier calque, un papier cartonné, un papier couché ou précouché, une feuille ou un film plastique, une feuille ou une lame de verre, une feuille de métal telle qu'une tôle, une fine lame de bois, un tissu, etc. Le papier peut avoir une main relativement importante supérieure ou égale à 0,9cm³/g, voire à 1,1 cm³/g, de préférence supérieure ou égale à 1,2cm³/g, plus préférentiellement supérieure ou égale à 1,3cm³/g, plus particulièrement supérieure ou égale à 1,4cm³/g, et encore plus particulièrement supérieure ou égale à 1,5cm³/g.

Le procédé selon l'invention peut permettre de réaliser une feuille ayant à la fois une main et un lissé importants, ce qui n'était pas possible avec la technique antérieure. Il n'était en effet pas possible dans la technique antérieure de réaliser une feuille avec une main importante et une grande qualité de surface. Un substrat ayant une main importante peut être formé d'un matériau peu coûteux. Dans le cas d'un papier, la pâte à papier utilisée peut comprendre des fibres cellulosiques, un liant, et une faible proportion de charges et/ou d'adjuvants, tels que de l'amidon.

Dans un exemple particulier de réalisation de l'invention, le procédé selon l'invention entraîne une faible diminution, de 2 à 5% environ, de la main du substrat papier.

Lors de l'étape b/ du procédé, la face à revêtir du substrat ou la face libre de la couche de base ou d'une couche supplémentaire de la structure multicouche, est encollée au moyen d'une colle appropriée.

En variante, les deux faces précitées du substrat et de la structure multicouche sont encollées simultanément, ou l'une après l'autre. Avantageusement, seule la face libre de la couche de base ou d'une couche supplémentaire de la structure multicouche est encollée.

L'encollage consiste à déposer une couche de colle sur la ou les faces précitées, par une technique quelconque, telle que par exemple par héliogravure. La colle peut être du type thermique, non thermique, par réticulation UV ou par réaction chimique. La colle peut être déposée sur la ou sur chaque face précitée sous forme liquide ou non liquide (dans le cas par exemple d'un film thermoadhésif). Cette colle est par exemple choisie parmi les polymères suivants : acrylique, polyuréthane, polyméthylméthacrylate, styrène butadiène, vinyl acétate, polyamide, nitrocellulose ou de toute autre cellulose, polyvinylalcool ou amidon. La ou chaque couche de colle déposée peut avoir une épaisseur inférieure ou égale à 10µm, et de préférence inférieure ou égale à 3µm.

Dans un cas particulier de réalisation de l'invention, la colle est déposée sur la face précitée de la structure multicouche pendant la préparation de cette structure. Cette colle fait alors partie à part entière de la structure multicouche. La colle peut être formée par une couche adhésive thermoactivable, cette couche étant activée par chauffage lors de l'application de la structure multicouche sur le substrat (receveur).

La nature de la colle et le processus de collage (sur le film et/ou sur le substrat / papier) peuvent avoir une influence importante sur l'état de surface final de la feuille. Il est par exemple important que la dépose de la colle soit uniforme et d'éviter la formation de cavités entre le substrat et la couche de base.

Concernant l'uniformité de la dépose de la colle, la dépose de la colle est de préférence homogène pour éviter des excès et/ou des manques de colle par endroit, ce qui se traduirait par une feuille finale présentant des rugosités de surface. Avantageusement, la colle s'étale parfaitement sur le support (film ou substrat) en ayant une tension de surface et une rhéologie adéquates.

Le mode d'enduction de la colle peut également avoir une importance. Les modes d'enduction qui génèrent le moins possible d'hétérogénéité de dépose, tels que l'héliogravure (reverse roll ou kiss coating) sont préférés. La dépose est de préférence choisie pour remplir au maximum les pores ou irrégularités de surface du substrat. A titre d'exemple, lorsqu'un papier a une rugosité moyenne (par exemple Sa) de surface de 20µm environ, une dépose de colle ayant une épaisseur d'au moins 10µm est préférable pour combler les pores. Le dépôt de colle est de préférence réalisé sur le substrat lorsque ce dernier est trop rugueux. Si la dépose sur un papier est insuffisante, il se forme alors des cavités entre la surface du papier et la couche de base. Lors de l'impression, ces cavités vont devenir des points de fragilité du papier qui pourront alors soit s'enfoncer, si on exerce une pression, soit s'arracher, si on exerce une traction.

Avantageusement, l'épaisseur de colle déposée sur le substrat et/ou la couche de base est égale à au moins la moitié de la rugosité moyenne de surface (par exemple Ra ou Sa) du substrat. Dans un mode de réalisation de l'invention, la colle est déposée sur au moins une face du substrat à l'étape b/, et l'épaisseur de la couche de colle déposée est au moins égale à la moitié de la rugosité moyenne de la face du substrat, et est de préférence égale à cette rugosité moyenne.

La colle peut être à base aqueuse, solvant, sans solvant, bi-composant ou mono-composant.

La colle permet de fixer la couche de base (ou une couche supplémentaire) sur le substrat et, le cas échéant, de compenser les irrégularités de surface du substrat. La colle comble notamment les creux de la face à revêtir du substrat et permet donc d'aplanir cette face, sans toutefois modifier les caractéristiques du substrat, telles que sa main.

L'étape b/ du procédé consiste ensuite à appliquer la face précitée du substrat sur la face précitée de la structure multicouche, de façon à les laminer ou à les contrecoller. La couche de base est alors prise en sandwich entre d'une part le substrat et la colle (et le cas échéant une ou plusieurs couches supplémentaires), d'un côté, et d'autre part le film plastique et le revêtement antiadhésif, de l'autre côté.

Dans le cas où la colle utilisée pour coller le substrat sur la structure multicouche est du type thermoadhésif, l'application du substrat sur la structure multicouche est réalisée à chaud, à une température donnée, qui est par exemple comprise entre 50 et 200°C environ. En variante, l'application et le collage du substrat sur la structure multicouche peuvent être réalisés à température ambiante.

Une pression peut être nécessaire pour assurer une bonne adhésion de la couche de base sur le substrat, par l'intermédiaire de la colle.

La température et/ou la pression utilisées lors de l'application et du collage ne doivent toutefois pas modifier les caractéristiques de la couche de base, et en particulier l'état de surface de sa face située du côté du film plastique. Par exemple, la couche de base ne doit pas être ramollie par l'application d'une température élevée, car cela pourrait entraîner une modification et/ou une diminution de la qualité de surface de sa face, située du côté du film plastique.

L'étape c/ du procédé consiste ensuite à retirer le film plastique de la couche de base et du substrat, de façon à ce que la couche de base (et le cas échéant la ou les couches supplémentaires précitées de la structure multicouche) restent sur le substrat. La couche de base, et le cas échéant la ou les couches supplémentaires, sont donc transférées depuis le film plastique appelé donneur, de la structure multicouche, sur le substrat appelé receveur.

Le procédé peut également comprendre une étape de réticulation ou de murissement de la colle avant de retirer le film.

Comme expliqué dans ce qui précède, la totalité du revêtement antiadhésif reste de préférence sur le film plastique et est alors retirée de la couche de base, lors du retrait du film plastique. La face de la couche de base, qui était située du côté du film plastique dans la structure multicouche, est donc mise à nue.

Le transfert de la couche de base de la structure multicouche sur le substrat, aux étapes b/ et c/ du procédé, peut être réalisé de la façon suivante, lorsque le substrat et la structure multicouche se présentent sous forme de bandes continues.

Le laminage ou contrecollage de la structure multicouche et du substrat peut être réalisé en passant ces deux éléments entre deux rouleaux mécaniques parallèles et adjacents, tournant dans des sens opposés. L'épaisseur du produit obtenu est notamment fonction de la distance entre les rouleaux. Une fois que la colle est sèche ou solidifiée, le film plastique est retiré de la feuille pendant que celle-ci est entraînée par un autre rouleau mécanique.

En variante, on peut encoller soit la structure multicouche soit le substrat, faire sécher la colle, puis mettre en contact ces deux éléments l'un contre l'autre en appliquant une température et une pression déterminées.

Le procédé peut en outre consister en ce que, avant l'étape b/, la face précitée du substrat est précouchée avec au moins une couche de lissage comportant un ou plusieurs polymères thermoplastiques (tels qu'au moins une polystyrène, un polyuréthane, un acrylique, etc.) ou un mélange de pigments (tels que les kaolins, les carbonates de calcium, le talc, le dioxyde de titane, etc., et leurs mélanges) et d'au moins un liant (tel que à base d'acrylique, de polyuréthane, de polyméthylméthacrylate, de styrène butadiène, de vinyl acétate, de polyamide, de nitrocellulose ou de toute autre cellulose, d'amidon ou de PVA).

Cette face précouchée du substrat peut en outre être calandrée, avant l'étape b/, pour augmenter son lissé.

En ce qui concerne l'étape d1/ de dépôt du film électro-conducteur, ce film peut être formé en métal ou en polymère conducteur ou tout autre matériau électro-conducteur. Il peut être fabriqué indépendamment de la feuille puis être rapporté et fixé, par exemple par collage, sur la couche de base de la feuille. En variante, il est formé *in situ* sur la couche de base de la feuille.

Les informations ci-dessous concernent l'étape d2/, selon laquelle la couche de base est imprimable.

On entend par couche imprimable, une couche pouvant être imprimée par toute technique d'impression, et en particulier par impression Offset, jet d'encre, laser, héliographie, flexographie, sérigraphie, toner sec, toner liquide, électrophotographie, lithographie, etc. Une couche imprimable comprend un liant et peut comprendre en outre des pigments.

Selon une caractéristique de l'invention, l'impression de la couche de base n'entraîne pas de modification structurelle de celle-ci, et en particulier de changement d'état ou de phase de celle-ci (tel par exemple qu'un passage d'un état solide à un état liquide puis retour à l'état solide).

Lorsque la couche de base de la structure multicouche est une couche imprimable, elle peut être choisie parmi un vernis imprimable, un couchage papetier, etc.

Dans la présente demande, on entend par vernis imprimable, une substance à base de polymère d'acrylique, de polyuréthane, de polyméthylméthacrylate, de styrène butadiène, de vinyl acétate, de polyamide, de nitrocellulose ou de toute autre cellulose, de polyvinylalcool, d'amidon, etc. Cette substance est en général déposée sous forme liquide et solidifiée par séchage/chauffage ou par rayonnement UV ou électronique.

On entend par couchage papetier (de l'anglais *paper coating*) ou composition de couchage, une composition comportant un liant et éventuellement des pigments. Le liant de la couche de base imprimable peut comprendre un liant principal et éventuellement un co-liant.

Dans la présente demande, on entend par liant principal un liant qui est majoritaire dans la couche par rapport aux autres liants, en particulier par rapport au(x) co-liant(s).

Le liant principal est avantageusement un latex synthétique tel qu'un copolymère styrène-butadiène (XSB) et/ou un copolymère styrène-acrylate (SA). Le liant peut comprendre une combinaison de deux latex, tels que le XSB et le SA, dans des proportions comprises entre 55 et 80% pour le XSB et entre 20 et 45% pour le SA (en poids sec par rapport aux poids sec cumulés de ces liants), voire entre 60 et 70% pour le XSB et entre 30 et 40% pour le SA (en poids sec par rapport aux poids sec cumulés de ces liants). La couche de base peut comprendre un liant à base d'acrylique, de polyuréthane, de polyméthylméthacrylate, de styrène butadiène, de vinyl acétate, de polyamide, de nitrocellulose ou de toute autre cellulose, de polyvinylalcool, d'amidon, ou d'un mélange de ceux-ci.

Le co-liant est de préférence un promoteur d'adhérence à base d'un copolymère éthylène - acide acrylique (EAA). Ce co-liant peut permettre d'augmenter la brillance de la couche de base et d'améliorer le phénomène d'adhésion de certaines encres sur la couche de base, telles que les encres à toner liquide du type HP indigo.

Les pigments peuvent être majoritaires par rapport au liant dans un couchage papetier. Les pigments ont par exemple une taille moyenne ou un diamètre moyen inférieur ou égal à 2µm environ, voire à 1µm, et par exemple de l'ordre de 0,5µm. Les pigments peuvent être choisis parmi les carbonates de calcium, les kaolins, le dioxyde de titane, le talc, les silices, mica, et particules nacrées, les pigments plastiques (polystyrène (PS), polyuréthane (PU), styrène acrylique, etc. - tels que le pigment Ropaque Ultra-E de la société Rohm&Haas), les pigments métalliques (argent, cuivre, or, etc. - tels que le pigment Brookprint Sparkle Silver de la société Rondot S.A.), et leurs mélanges. Ce sont avantageusement des carbonates de calcium.

La matière plastique utilisée dans la couche de base (en tant que liant et/ou pigments) est facilement fragmentable et ne pollue pas la pâte à papier lorsqu'elle est recyclée. Au contraire, les films plastiques gardent une cohésion et colmatent les filtres lors de la remise en suspension de la pâte à papier. Les liants hydrosolubles (tels que l'amidon, le polyvinylalcool (PVA), etc.) sont particulièrement avantageux à ce sujet car ils se dispersent dans l'eau lors du recyclage.

Le couchage papetier peut en outre comprendre un dispersant et/ou un modificateur rhéologique et/ou un colorant et/ou un agent de surface ou d'étalement et/ou un additif conducteur. Cet additif conducteur peut être utilisé pour diminuer la résistivité surfacique de la feuille.

Avantageusement, dans le cas où le papier formant le substrat de la feuille est un papier calque, la couche de base imprimable présente une transparence et a un taux de liant supérieur à 30% en poids sec par rapport au poids total de matière sèche de la couche, de façon à ce que la feuille obtenue par le procédé présente une certaine transparence. L'utilisation d'un papier calque est particulièrement avantageuse pour autoriser le passage et la récupération de l'énergie d'un rayonnement à travers la feuille, et est donc particulièrement adaptée pour la réalisation de cellules solaires ou photovoltaïques. La transparence d'un papier calque dépend notamment de son grammage et est par exemple de l'ordre de 60-70% pour un papier calque de 62g/m² et de 40-50% pour un papier calque de 175g/m²_{.}

Les particules métalliques peuvent être sous forme d'une poudre. Il existe donc des espaces entre elles lorsqu'elles sont déposées sur la couche de base. L'étape de recuit permet de coalescer ou de fritter les nanoparticules entre elles et ainsi autoriser le passage de courant entre celles-ci. La couche conductrice déposée a par exemple une épaisseur inférieure ou égale à 1µm, qui peut être inférieure ou égale à 300nm, et qui est par exemple de l'ordre de 30nm. Cette épaisseur relativement faible permet toutefois de conférer à la feuille une bonne conductivité. En effet, du fait du lissé important de la couche de base, il n'est pas nécessaire de déposer une couche conductrice épaisse sur la couche de base car la couche d'encre fine reste continue en surface. Il est envisageable de déposer une couche d'or d'une épaisseur comprise entre 20 et 100nm, et par exemple entre 30 et 40nm environ.

Le recuit peut être réalisé dans une étuve (par exemple, à une température comprise entre 150 et 200°C et pendant 5 à 10min environ), sur une plaque chauffante, dans un four photonique ou dans un sécheur infrarouge. Le four photonique (par exemple l'appareil PuiseForge® 3300 de la société NovaCentrix) permet de réaliser un frittage efficace des particules conductrices des encres, qui sont de préférence déposées sur la couche de base par sérigraphie. Les particules conductrices peuvent être des particules d'argent, de cuivre, d'alliages divers, etc. Il est par exemple réalisé à une température supérieure ou égale à 100°C, de préférence supérieure ou égale à 120°C, et plus préférentiellement supérieure ou égale à 150°C, ce qui est très avantageux car cela permet d'obtenir une bonne cohésion des particules ou matériaux électro-conducteurs des encres et assurent donc une meilleure conductivité électrique de la couche, la feuille présentant une excellente stabilité thermique à 150-170°C. Les films plastiques (PET, PEN, etc.) de la technique antérieure ne peuvent pas être soumis à de telles températures de recuit car ils se dégradent en général à partir de 120-140°C. Le temps de recuit peut être inférieur ou égal à 5 minutes et est par exemple compris entre 2 et 3 minutes. Le recuit peut être réalisé en maintenant la feuille en traction (le long d'un axe ou de deux axes perpendiculaires, par exemple) de façon à limiter les variations de dimensions de la feuille lors du recuit. De manière générale, la feuille présente de bonnes stabilités thermique et dimensionnelle lors des recuits ou lors de traitements quelconques.

Le procédé selon l'invention peut également comprendre une ou plusieurs des étapes suivantes :
- retirer par photolithographie ou par ablation laser certaines zones prédéterminées de la couche électro-conductrice de la feuille ;
- répéter au moins une fois l'étape d2/, chaque étape d2/ qui suit une étape d2/ étant séparée de cette étape par une étape intermédiaire de repos de la feuille, pendant laquelle la feuille est destinée à récupérer sensiblement sont taux d'humidité initial ; et
- réaliser, avant l'étape d2/, une étape consistant à soumettre la couche de base à un traitement plasma ; ce traitement permet de modifier l'état de surface de la couche de base et de la rendre plus hydrophobe, ce qui permet d'éviter que l'encre s'étale et mouille trop la couche de base (et se traduit par une précision et une résolution accrues des motifs imprimés sur la couche) ; avantageusement, la couche de base subit un traitement plasma au fluor (SF₆).

Le procédé peut également comprendre une étape consistant à réaliser avec la feuille au moins une résistance, une capacité, un transistor, une puce RFID, une antenne, un circuit logique, un interrupteur à membrane (SWITCH), une cellule photovoltaïque, une batterie, un moyen de collecte d'énergie, un système de rétroéclairage, un moyen d'affichage ou d'éclairage électroluminescent tel qu'une diode électroluminescente inorganique ou organique (OLED), un capteur, un clavier à membrane, ou toute combinaison de ces composants.

Le procédé peut en outre être caractérisé en ce que :
(i) dans la structure multicouche préparée à l'étape a), la couche de base s'étend sur une surface inférieure à celle de la face précitée du film plastique, et/ou
(ii) la structure multicouche et le substrat sont contrecollés à l'étape b) sur une surface inférieure à celle de la face précitée de la feuille, et/ou
(iii) le film plastique retiré à l'étape c) a au moins une dimension parmi sa longueur et sa largeur qui est inférieure à la ou les dimensions correspondantes de la face précitée de la feuille, et/ou
(iv) la feuille obtenue à l'étape c) est découpée puis au moins un morceau découpé de cette feuille est collé sur le substrat d'une autre feuille,
de façon à ce que la feuille comporte au moins une face ayant au moins une zone de plus grand lissé que le reste de cette face, cette zone comportant une couche externe lisse qui est formée par la couche de base et qui s'étend sur le substrat de la feuille sur une surface inférieure à celle de ladite face.

De préférence, l'application de la structure multicouche sur le substrat est réalisée à l'étape b) au moyen d'une presse embosseuse qui est destinée à appliquer une pression dans la zone précitée, ou au moyen d'une presse de dorure à chaud qui permet de ramollir la colle utilisée à l'étape b), qui est du type thermosensible.

Le précédé peut comprendre, avant l'étape c), une étape d'impression de la face de la structure multicouche située du côté opposé au film plastique avec des encres électro-conductrices, ou de dépôt d'un revêtement électro-conducteur sur cette face.

De préférence, pendant l'étape a), le revêtement antiadhésif déposé sur le film plastique est imprimé avec des encres électro-conductrices ou est recouvert d'un revêtement électro-conducteur.

L'invention concerne également un procédé de fabrication d'un produit électro-conducteur comprenant la réalisation, au moyen d'une feuille, de préférence , obtenue par un procédé tel que décrit ci-dessus, d'au moins une résistance, une capacité, un transistor, une puce RFID, une antenne, un circuit logique, un interrupteur à membrane (SWITCH), une cellule photovoltaïque, une batterie, un moyen de collecte d'énergie, un système de rétroéclairage, un moyen d'affichage ou d'éclairage

électroluminescent tel qu'une diode électroluminescente inorganique ou organique (OLED), un capteur, un clavier à membrane, ou toute combinaison de ces composants, notamment par mise en oeuvre d'une étape d'impression de la couche de base et/ou d'une étape de retrait par photolithographie ou par ablation laser de certaines zones prédéterminées de la couche électro-conductrice.

La divulgation décrit encore un produit électro-conducteur, caractérisé en ce qu'il comprend une feuille, de préférence , telle qu'obtenue par un procédé tel que décrit ci-dessus, ladite feuille étant convertie en un produit comportant au moins une résistance, une capacité, un transistor, une puce RFID, une antenne, un circuit logique, un interrupteur à membrane (SWITCH), une cellule photovoltaïque, une batterie, un moyen de collecte d'énergie, un système de rétroéclairage, un moyen d'affichage ou d'éclairage électroluminescent tel qu'une diode électroluminescente inorganique ou organique (OLED), un capteur, un clavier à membrane, ou toute combinaison de ces composants, notamment par mise en oeuvre d'une étape d'impression de la couche de base et/ou d'une étape de retrait par photolithographie ou par ablation laser de certaines zones prédéterminées de la couche électro-conductrice.

Dans le cas précité, la face traitée de chaque feuille est entièrement revêtue de la structure multicouche dont le film plastique est destiné à être retiré. Des quantités importantes de film plastique, de revêtement antiadhésif et de colle peuvent donc être utilisées, ce qui augmente le coût du produit final.

Du fait de l'augmentation de ce coût, le procédé peut être réservé à des applications spécifiques et pourrait ne pas être utilisé dans d'autres applications.

Par ailleurs, l'étape de contre-collage d'un papier nécessite, du fait notamment des dimensions de la structure multicouche, une machine particulière qui est destinée à traiter le papier après sa fabrication par une machine à papier, c'est-à-dire *off line.*

Un autre aspect de l'invention a notamment pour but d'apporter une solution simple, efficace et économique à ce problème.

Elle propose à cet effet un procédé de fabrication d'une feuille dont au moins une face comporte au moins une zone de plus grand lissé que le reste de la face, cette zone comportant une couche externe lisse qui s'étend sur un substrat de la feuille sur une surface inférieure à celle de ladite face, le procédé comprenant les étapes consistant à :
a/ préparer ou apporter une structure multicouche comprenant au moins, ou constituée par, un film plastique, un revêtement antiadhésif, et une couche de base, le revêtement antiadhésif étant intercalé entre une face du film plastique et la couche de base,
b/ encoller une face du substrat d'une feuille et/ou la face de la structure multicouche située du côté opposé au film plastique, et appliquer la face précitée du substrat contre la face précitée de la structure multicouche, de façon à contrecoller la structure multicouche et le substrat,
c/ retirer le film plastique et le revêtement antiadhésif de la couche de base, la couche de base définissant ladite couche externe lisse,
caractérisé en ce que :
(i) dans la structure multicouche préparée à l'étape a), la couche de base s'étend sur une surface inférieure à celle de la face précitée du film plastique, et/ou
(ii) la structure multicouche et le substrat sont contrecollés à l'étape b) sur une surface inférieure à celle de la face précitée de la feuille,
(iii) le film plastique retiré à l'étape c) a au moins une dimension parmi sa longueur et sa largeur qui est inférieure à la ou les dimensions correspondantes de la face précitée de la feuille et/ou
(iv) la feuille obtenue à l'étape c) est découpée puis au moins un morceau découpé de cette feuille est collé sur le substrat d'une autre feuille.

Dans la présente demande, on entend par zone (d'une face) de la feuille, une partie seulement (de la face) de la feuille. La zone a par exemple au moins une dimension parmi sa longueur et sa largeur qui est inférieure à la ou les dimensions correspondantes de la feuille. La zone peut par exemple avoir une forme de bande et s'étendre le long d'un des bords longitudinaux de la feuille. La zone peut avoir une surface représentant moins de 50%, de préférence moins de 20%, et plus préférentiellement moins de 10%, de la surface (de la face) de la feuille.

Selon l'invention, une partie seulement de la face du substrat de la feuille est recouverte par la couche externe lisse précitée. Cela est particulièrement avantageux car cela permet d'utiliser des quantités de film plastique, de revêtement antiadhésif et/ou de colle inférieures à celles utilisées dans les technologies antérieures et permet donc de réduire le coût de la fabrication de la feuille et d'envisager de multiples applications qui n'étaient pas envisageables dans la technique antérieure pour des raisons économiques.

Dans un cas particulier de fabrication d'un papier, le surcoût lié à l'application du procédé à ce papier est relativement faible, ce qui permet d'envisager l'utilisation du papier dans plusieurs applications différentes.

La couche externe précitée confère à la zone un lissé relativement important, qui est supérieur à celui du reste de la feuille c'est à dire aux parties de la feuille qui ne comportent pas cette couche. Ce lissé est induit par celui du film plastique de la structure multicouche, et ne dépend donc pas de celui du substrat de base utilisé. A titre d'exemple, la ou chaque zone précitée peut avoir un lissé Bekk supérieur à 900s (de préférence supérieur à 1000s, et plus préférentiellement supérieur à 2000s), le reste de la feuille ayant un lissé Bekk inférieur à 900s (de préférence inférieur à 500s, et plus préférentiellement inférieur à 200s).

Par ailleurs, la couche de base peut avoir des propriétés magnétiques (notamment ferromagnétiques dans le cas de réalisation de self-inductance, bobine et antenne) ou d'autres propriétés telles que notamment une propriété barrière (la couche de base peut être associée à un film d'aluminium ou avoir des propriétés proches de celles d'un film d'aluminium), une propriété modifiant son apparence (la couche de base peut être colorée, réfléchissante, etc.), une propriété optique ou optoélectronique (la couche de base peut former un guide d'onde), et/ou une fonction de sécurité (la couche de base peut comprendre une micro-impression, un hologramme, être iridescente, etc.).

La feuille obtenue par le procédé selon l'invention présente en outre un net avantage en termes de recyclage car les parties de la feuille non recouvertes d'une couche de base lisse peuvent être recyclées de façon classique. Les parties lisses de la feuille peuvent être délaminées ou découpées pour être recyclées indépendamment du reste de la feuille en vue de récupérer les éventuels matériaux électro-conducteurs qu'elle contient.

La structure multicouche peut comprendre plus d'une couche, c'est-à-dire qu'elle peut comprendre une ou plusieurs autres couches intercalées entre le revêtement antiadhésif et la couche de base. Dans le cas de structures multicouches, l'avantage est que le lissé de la première couche se transmet aux couches suivantes. Cela est d'autant plus intéressant que la stabilité thermique du papier permet un empilement stable assurant une qualité électrique et optique du système à réaliser sur une large surface (car les températures de recuits successifs sont élevées et donc les pertes de charges sont faibles sur des longues distances du fait de l'excellente conductivité).

Dans le cas de couches électro-conductrices transparentes (de type PEDOT:PSS par exemple), le recuit thermique est la seule façon d'avoir de la conductivité (on ne peut pas utiliser de « *flash sintering »* du fait de sa transparence"), or cette couche est généralement une des dernières à être appliquée sur le substrat dans le cas de multicouches. Notre papier ultra-lisse permet donc de réduire la quantité de polymères conducteurs transparents à appliquer.

Dans le premier cas (i) précité du procédé selon l'invention, dans la structure multicouche préparée à l'étape a), la couche de base s'étend sur une surface inférieure à celle de la face précitée du film plastique. La revêtement antiadhésif qui est pris en sandwich entre la couche de base et le film plastique peut recouvrir la totalité du film plastique ou une partie seulement de ce film. Avantageusement, la couche de base recouvre sensiblement la totalité du revêtement antiadhésif qui recouvre une partie seulement du film plastique. La couche de base peut avoir une forme et des dimensions similaires à celles de la zone de plus grand lissé à former sur la feuille.

Dans le second cas (ii) précité du procédé, la structure multicouche et le substrat de la feuille sont contrecollés à l'étape b) sur une surface inférieure à celle de la feuille. La colle peut être déposée sur une partie seulement de la structure multicouche et/ou sur une partie seulement du substrat de la feuille. La ou les parties encollées peuvent avoir une forme et des dimensions similaires à celles de la zone de plus grand lissé à former sur la feuille.

Les cas (i) et (ii) peuvent être combinés. Dans ce cas, la couche de base s'étend sur une surface inférieure à celle du film plastique dans la structure multicouche préparée à l'étape a), et la structure multicouche et le substrat de la feuille sont contrecollés à l'étape b) sur une surface inférieure à celle de la feuille.

Dans le cas (iii) précité du procédé, le film plastique retiré à l'étape c) a au moins une dimension parmi sa longueur et sa largeur qui est inférieure à la ou les dimensions correspondantes de la face précitée de la feuille.

Les cas (i) et (iii) peuvent être combinés. La couche de base s'étend sur une surface inférieure à celle du film plastique dans la structure multicouche préparée à l'étape a), et le film plastique retiré à l'étape c) est plus petit que la feuille.

Les cas (ii) et (iii) peuvent être combinés. La structure multicouche et le substrat de la feuille sont alors contrecollés à l'étape b) sur une surface inférieure à celle de la feuille, et le film plastique retiré à l'étape c) est plus petit que la feuille.

Enfin, les cas (i), (ii) et (iii) peuvent être combinés. Dans ce cas, la couche de base s'étend sur une surface inférieure à celle du film plastique dans la structure multicouche préparée à l'étape a), la structure multicouche et le substrat de la feuille sont contrecollés à l'étape b) sur une surface inférieure à celle de la feuille, et le film plastique retiré à l'étape c) est plus petit que la feuille.

Dans le cas (iv) précité du procédé, la feuille obtenue à l'étape c) est découpée puis au moins un morceau découpé de cette feuille est collé sur le substrat d'une autre feuille. Ce cas particulier peut également être combiné aux autres cas précités.

Dans le cas où la feuille comprend un substrat en papier, l'invention est particulièrement avantageuse car elle permet d'une part d'équiper ce papier d'une zone de plus grand lissé dans un endroit prédéterminé et d'autre part de conserver le reste de la feuille pour une présentation d'informations par exemple, et en particulier pour l'impression d'informations si le papier est imprimable.

L'invention peut en outre être utilisée sur tout type de substrat. Elle peut être utilisée dans l'art graphique, pour des lettres à en-tête, pour des enveloppes, des *post*-*it*®, des papiers sécurisés, etc.

La feuille obtenue par le procédé selon l'invention a de plus l'avantage de pouvoir être réalisée en ligne (*in line*) dans une machine à papier, par exemple dans une section finale de séchage de cette machine à papier, ou hors ligne (*off line*) dans une machine de découpe ou de finition de papier.

Le ou chaque morceau découpé est par exemple sous forme d'une bande ayant une longueur de plusieurs mètres. Ce morceau de forme allongée peut être enroulé sur un rouleau et déroulé du rouleau (jusqu'à des vitesses de plusieurs centaines de mètres par seconde), ce qui est particulièrement avantageux dans l'industrie papetière. La structure multicouche est suffisamment résistante, du fait notamment de la présence du film plastique, pour subir ces enroulements/déroulements.

L'application de la structure multicouche sur le substrat peut être réalisée à l'étape b) au moyen d'une presse embosseuse qui est destinée à appliquer une pression dans la ou chaque zone précitée de la structure multicouche, ou d'une presse de dorure à chaud destinée à ramollir la colle utilisée à l'étape b), qui est du type thermosensible.

Le procédé peut comprendre, avant l'étape c), une étape d'impression de la face de la structure multicouche située du côté opposé au film plastique avec des encres électro-conductrices, ou de dépôt d'un revêtement électro-conducteur sur cette face. La structure multicouche est ainsi rendue électro-conductrice avant le transfert de la couche de base sur le substrat de la feuille. La couche ou le revêtement électro-conducteur est situé sur la face de la structure multicouche située du côté opposé au film plastique et peut donc être située sur une face de la couche de base. Lors de l'étape c), cette face est collée contre le substrat de la feuille. Dans ce cas, la couche électro-conductrice (revêtement ou encres) est protégée par la couche de base qui s'étend au dessus de cette couche électro-conductrice. L'impression ou le dépôt précité peut être réalisé avant la découpe de la structure multicouche décrite précédemment.

Pendant l'étape a), le revêtement antiadhésif déposé sur le film plastique peut être imprimé avec des encres électro-conductrices ou être recouvert d'un revêtement électro-conducteur. La couche de base est alors déposée directement sur les encres ou le revêtement à l'étape a).

Dans le cas (iv) précité, la couche de base est de préférence transférée sur un substrat ou une feuille mince.

La feuille ou le substrat de la feuille peut être revêtu d'un revêtement anti-adhérent ou formé d'un film plastique, et/ou être découpé avant le transfert de la couche de base.

Le procédé selon l'invention peut en outre comprendre une étape de traitement de la feuille en vue d'augmenter sa résistance à l'humidité. La feuille peut être traitée REH (résistance à l'état humide), par exemple au moyen d'agents REH qui évitent la dégradation de la feuille à l'état humide. Il est connu qu'un polyamide amine épichlorhydrine peut conférer à la feuille des propriétés de REH. Par exemple, 1 % de Kymene® 617 (société Hercules) dans la feuille permet d'avoir une résistance à la traction de 15% à l'état humide par rapport à l'état sec.

Dans un mode particulier de réalisation de l'invention, après l'étape c) et avant l'étape d1) ou d2), la feuille est embossée de façon à former au moins une zone en creux sur une face de la feuille. Le dépôt ou l'impression de l'étape d1) ou d2) peut alors être réalisé dans la zone en creux uniquement de la feuille. La surface libre supérieure du film déposé ou des encres imprimées peut être sensiblement alignée avec la face précitée de la feuille sur laquelle la zone en creux à été formée.

La présente divulgation décrit également une feuille pouvant être obtenue par le procédé décrit ci-dessus, dont au moins une face comporte au moins une zone de plus grand lissé que le reste de la face, cette zone comportant une couche externe lisse qui s'étend sur une surface inférieure à celle de la face, ladite couche externe lisse étant électro-conductrice ou revêtue d'une couche électro-conductrice, la couche électro-conductrice définissant au moins un des éléments suivants ou étant reliée à au moins un des éléments suivants : une résistance, une capacité, un transistor, une
puce RFID, une antenne, un circuit logique, un interrupteur à membrane (SWITCH), une cellule photovoltaïque, une batterie, un moyen de collecte d'énergie, un système de rétroéclairage, un moyen d'affichage ou d'éclairage électroluminescent tel qu'une diode électroluminescente inorganique ou organique (OLED), un clavier à membrane, et un capteur. Les deux faces de la feuille peuvent comporter au moins une zone de ce type.

La feuille peut comprendre au moins deux zones du type précité, les couches électro-conductrices de ces zones pouvant être reliées électriquement entre elles, par exemple par des conducteurs contenus dans la feuille.

Ces couches électro-conductrices peuvent avoir des propriétés et/ou des fonctions électroniques différentes.

La ou chaque zone peut avoir une surface représentant moins de 50%, de préférence moins de 20%, et plus préférentiellement moins de 10%, de la surface de la face précitée de la feuille.

La feuille comprend par exemple un substrat en papier.

La ou chaque couche électro-conductrice peut comprendre (ou être revêtue de) de plusieurs diodes de taille micrométrique, telles que celles décrites dans la demande WO2012/031096.

La présente divulgation décrit en outre une feuille pouvant être obtenue par le procédé décrit ci-dessus, dont au moins une face comporte au moins une zone de plus grand lissé que le reste de la face, cette zone comportant une couche externe lisse qui s'étend sur une surface inférieure à celle de la face, ladite couche externe lisse étant recouverte d'une couche optique et/ou optoélectronique formant par exemple un guide d'onde.

La zone peut comporter également au moins une couche électro-conductrice, qui est de préférence recouverte de micro-diodes destinées à émettre un rayonnement lumineux à la couche optique lorsqu'elles sont alimentées par un courant électrique.

La présente invention concerne également un procédé de fabrication d'une feuille équipée d'une couche optique telle qu'un guide d'onde, le procédé comprenant les étapes consistant à :
a/ préparer ou apporter une structure multicouche comprenant au moins, ou constituée par, un film plastique, un revêtement antiadhésif, et une couche de base, le revêtement antiadhésif étant intercalé entre une face du film plastique et la couche de base,
b/ encoller une face du substrat d'une feuille et/ou la face de la structure multicouche située du côté opposé au film plastique, et appliquer la face précitée du substrat contre la face précitée de la structure multicouche, de façon à contrecoller la structure multicouche et le substrat,
c/ retirer le film plastique et le revêtement antiadhésif de la couche de base, caractérisé en ce qu'une couche optique est déposée sur la couche de base.

La couche optique peut être déposée sur la couche de base par toute technique appropriée et par exemple par enduction. La couche optique comprend par exemple un ou plusieurs polymères.

L'invention est en effet particulièrement avantageuse pour fabriquer une feuille comprenant une couche optique telle qu'un guide d'onde(s). La couche de base peut servir de support à une couche de polymère par exemple destinée à guider une onde, telle qu'une onde électromagnétique ou lumineuse. L'onde transmise dans cette couche peut se réfléchir sur l'interface particulièrement lisse et plane entre les couches de base et de polymère, et peut ainsi être transmise au sein de la couche de polymère.

Dans la présente demande, on entend par couche optique, une couche ayant des propriétés optiques et en particulier une couche capable de réfléchir, absorber et/ou diffuser au moins une partie d'un rayonnement auquel elle est exposée. La couche optique peut par exemple former un guide d'onde et peut être formée d'un ou de plusieurs matériaux.

Ce mode de réalisation peut être combiné à chacune ou à tout ou partie des caractéristiques précitées, en particulier celles concernant la création d'une zone seulement de plus grand lissé sur la feuille et l'application d'une couche électro-conductrice sur la feuille.

Dans un cas particulier, la feuille est du type précité et comprend par une couche optique, la couche de base de cette feuille étant une couche électro-conductrice ou recouverte d'une couche électro-conductrice. Les zones où s'étendent les couches optique et électro-conductrice peuvent être indépendantes ou au moins en partie superposées ou reliées entre elles.

La feuille obtenue par le procédé selon l'invention peut en outre comprendre dans ou sur son substrat ou l'une de ses couches (de base, électro-conductrice, optique, etc.), des particules de matériau ferromagnétique. Ces particules permettent de modifier la perméabilité magnétique de la feuille de façon à modifier localement ou pas sa faculté de modifier un champ magnétique auquel elle est soumise. Cela peut par exemple permettre de rajouter des propriétés de filtrage de certaines ondes à la feuille. Dans le cas où la feuille comprendrait une bobine, celle-ci pourrait comprendre un coeur/noyau en fer, cobalt ou nickel pour augmenter sa perméabilité magnétique et ainsi améliorer son couplage avec une autre bobine de la feuille par exemple.

La feuille obtenue par le procédé selon l'invention peut en outre comprendre des moyens ou être traitée pour augmenter sa diffusivité thermique, celle-ci dépendant notamment de la capacité de la feuille à conduire la chaleur (sa conductivité thermique) et de sa capacité à accumuler la chaleur (capacité thermique). Dans le cas où la feuille est destinée à être associée à des équipements électroniques, il est préférable que la feuille ait une bonne diffusivité thermique pour que la chaleur générée en fonctionnement par ces équipements puisse être dissipée.

La dissipation de la chaleur peut être réalisée en surface ou dans la masse. Pour assurer une bonne dissipation de la chaleur en surface de la feuille, un film d'aluminium peut être intégré à la feuille, par exemple sous la couche de base ou sur le papier formant support. Ce film d'aluminium peut avoir une épaisseur de l'ordre de 15µm environ. Pour dissiper la chaleur dans la masse, il est possible de prévoir dans le matériau du papier support des charges spécifiques destinées à augmenter la conductivité thermique de ce papier. Ces charges peuvent être des nanoparticules de diamant, des fibres ou du noir de carbone, ou des oxydes, nitrures et carbures tels que par exemple : Al₂O₃, AIN, MgO₂, ZnO, BN, SiN₄, SiC et SiO₂.

L'invention sera mieux comprise et d'autres détails, caractéristiques et avantages de la présente invention apparaîtront plus clairement à la lecture de la description suivante faite à titre d'exemple non limitatif et en référence aux dessins annexés dans lesquels :
- la figure 1 représente de manière très schématique des étapes du procédé de fabrication d'une feuille selon l'invention ;
- la figure 2 représente de manière très schématique une variante de réalisation du procédé selon l'invention ;
- les figures 3 et 4 sont des images obtenues par un microscope électronique à balayage (MEB) de feuilles, la figure 4 correspondant à une feuille obtenue par le procédé selon l'invention ;
- les figures 5 et 6 représentent de manière très schématique des étapes d'une autre variante de réalisation du procédé selon l'invention ;
- les figures 7 à 11 représentent de manière très schématique plusieurs modes de réalisation du procédé selon l'invention ;
- la figure 12 représente des formes géométriques particulières pour le film plastique, la structure multicouche et/ou la couche de base lors de la mise en oeuvre du procédé selon l'invention ; et
- les figures 13 et 14 représentent de manière très schématique des étapes d'une variante de réalisation du procédé selon l'invention ;
- les figures 15 et 16 représentent de manière très schématique des étapes d'une autre variante de réalisation du procédé selon l'invention ;
- les figures 17 et 18 représentent des feuilles préparées par le procédé selon l'invention, et
- la figure 19 représente une autre feuille préparée par le procédé selon l'invention.

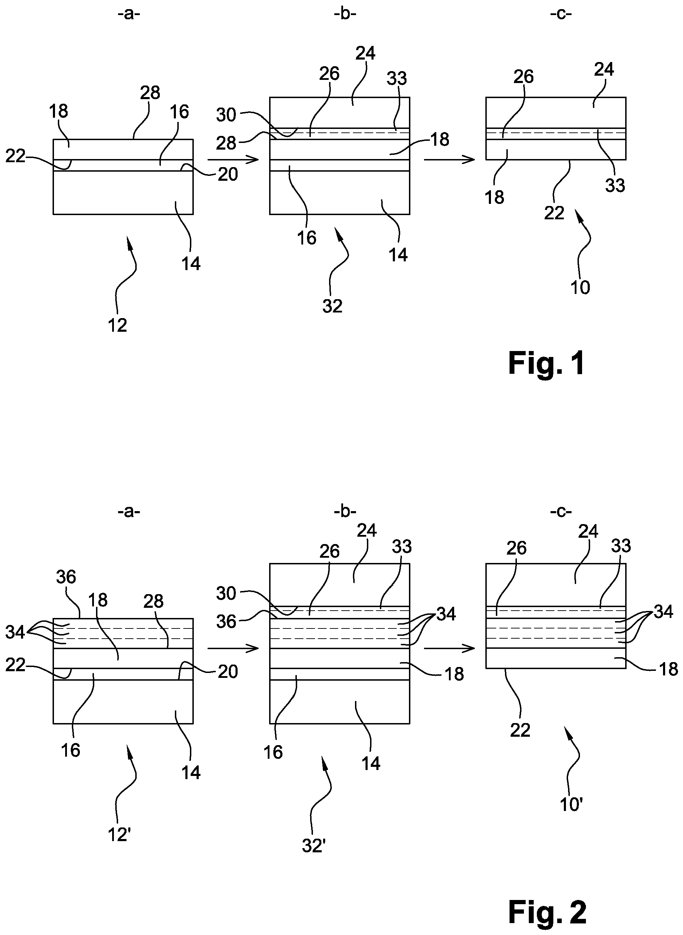

On se réfère d'abord à la figure 1 qui représente de manière très schématique des étapes a/, b/ et c/ du procédé de fabrication d'une feuille selon l'invention.

L'étape a/ du procédé consiste à préparer une structure multicouche 12 comportant un film plastique inférieur 14, un revêtement intermédiaire antiadhésif 16 et une couche supérieure de base 18. La préparation de cette structure 12 peut être réalisée en une étape ou plusieurs étapes successives.

Le revêtement antiadhésif 16 et la couche de base 18 peuvent être déposées simultanément sur le film plastique 14, par une technique de couchage au rideau par exemple.

En variante, le revêtement antiadhésif 16 est déposé sur le film plastique 14, puis la couche de base 18 est déposée sur le revêtement antiadhésif.

La qualité de surface de la face supérieure 20 du film plastique 14 est transmise à la face inférieure 22 de la couche de base 18 (par l'intermédiaire du revêtement antiadhésif 16). Les caractéristiques de surface de la face 22 de la couche de base sont donc définies par celles de la face 20 du film plastique 14.

Après séchage et/ou solidification de la couche de base, les caractéristiques de surface de la face 22 sont figées et ne sont pas destinées à être modifiées lors des autres étapes du procédé, et en particulier le transfert de la couche de base 18 sur un substrat 24, tel qu'un papier, à revêtir.

L'étape b/ du procédé consiste à déposer une couche ou un film de colle 26 sur la face supérieure 28 de la couche de base 18 ou sur la face inférieure 30 à revêtir du substrat 24, voire sur ces deux faces 28, 30, puis à appliquer ces faces 28, 30 l'une contre l'autre pour laminer ou contrecoller la structure multicouche 12 et le substrat 24, et ainsi former un produit laminé ou contrecollé 32.

L'étape c/ du procédé consiste à retirer le film plastique 14 et le revêtement antiadhésif 16 de la couche de base 18, de façon à ce que seule cette couche 18 reste (avec la colle 26) sur le substrat 24.

Ces étapes b/ et c/ peuvent être réalisées simultanément ou l'une après l'autre. Dans ce dernier cas, la colle 26 est avantageusement à l'état sec et/ou solidifiée lors du retrait du film plastique 14.

A l'issue de l'étape c/, la face 22 de la couche de base 18 est mise à nue, cette face étant relativement lisse.

La figure 2 représente une variante de réalisation du procédé selon l'invention, et diffère du procédé précédemment décrit en référence à la figure 1, notamment en ce que la structure multicouche 12' comprend en outre au moins une couche supplémentaire 34 déposée sur la face supérieure 28 de la couche de base 18.

Plusieurs couches supplémentaires 34 superposées peuvent être déposées (simultanément ou successivement) sur la face 28 de la couche de base 18.

Lors de l'étape b/, la face inférieure 30 du substrat 24 ou la face supérieure libre 36 de la couche supplémentaire 34 (la plus éloignée du film plastique, dans le cas ou la structure 12' comprend plusieurs couches supplémentaires) est recouverte de colle 26. En variante, ces deux faces 30, 36 son recouvertes de colle 26.

Lors de l'étape c/, la structure multicouche 12' et le substrat 24 sont contrecollés ou laminés, de façon à former un produit laminé ou contrecollé 32', puis le film plastique 14 et le revêtement antiadhésif sont retirées, de façon à mettre à nue la face lisse ou ultra lisse 22 de la couche de base 18 de la feuille 10'.

La nature de la couche de base 18 de la feuille peut varier selon le mode de réalisation du procédé selon l'invention.

La couche de base 18 peut être réalisée dans un matériau électro-conducteur et par exemple en métal. La couche de base 18 est par exemple formée d'une couche mince d'or qui est déposée sur le revêtement antiadhésif 16 par dépôt sous vide ou par toute autre technique appropriée.

En variante, la couche de base 18 peut en soit ne pas être électro-conductrice et peut alors être soit revêtue d'un film électro-conducteur (étape d1/ du procédé) soit imprimée avec une encre ayant des propriétés électriques (étape d2/).

Dans le cas où la couche de base 18 est recouverte d'un film métallique, celui-ci peut être formé *in situ* sur la couche de base ou rapporté et fixé, par exemple par collage, sur la couche de base. Ce film est par exemple un film d'or.

Dans le cas où la couche de base 18 est imprimable, elle peut être formée d'une résine ou d'un vernis imprimable ou d'un couchage papetier comportant un liant et éventuellement des pigments. La couche 18 est imprimable par toute technique appropriée, l'encre étant destinée à être déposée sur la face lisse 22 de la feuille 10.

L'encre peut comprendre des particules métalliques, des particules de carbone et/ou des polymères conducteurs, les particules pouvant être micrométriques ou nanométriques. L'étape d2/ peut comprendre une sous-étape dans laquelle la feuille imprimée est soumise à une étape de recuit pour que la couche d'encre forme une couche continue électro-conductrice. C'est par exemple le cas lorsque l'encre comprend des particules métalliques qui sont destinées à se coalescer lors de l'étape de recuit.

Tous les modes de réalisation permettent de fabriquer une feuille électro-conductrice, c'est-à-dire une feuille comportant au moins une couche présentant une bonne conductivité électrique, et en particulier ayant une résistance par carré inférieure à 0,3Ω/sq, de préférence inférieure à 0,15Ω/sq, et par exemple jusqu'à une résistance de l'ordre de 0,05Ω/sq.

La mesure de la résistance par carré d'une feuille selon l'invention peut être réalisée au moyen d'un appareil ou dispositif 4 pointes. Cette méthode utilise des contacts ponctuels disposés à la surface de la feuille. Ces contacts sont réalisés par des pointes métalliques. Deux pointes servent à amener un courant et deux autres pointes servent à mesurer une tension. Les quatre pointes sont disposées aux quatre coins d'un carré virtuel à la surface de la feuille ou sont alignées les uns derrières les autres sur une ligne virtuelle à la surface du papier. Il est possible d'utiliser un dispositif 4 pointes Jandel (universal Probe) couplé à un générateur de courant Jandel RM3 qui fournit une gamme de courant allant de 10nA à 99Ma. Les résistances mesurées sont exprimées en Ohm par carré (ohm/□ ou Ω/sq) et elles sont notées R□. L'appareil mesure le rapport ΔV/I qui peut être relié à la résistivité de la feuille. On se place dans le cas d'une couche mince d'épaisseur e et de résistivité p. L'épaisseur étant négligeable devant les autres dimensions, un modèle bidimensionnel de la conduction peut être mis en place et qui donne : V/I = K.ρ/e = K.R□. K est un coefficient sans dimension caractéristique de la géométrie 2D. Le rapport p/e caractérise la couche, il est noté R□ (ohm/□). Le coefficient K peut être calculé analytiquement dans des cas simples particuliers : K = log(2)/ π.

Des exemples illustrant la présente invention vont maintenant être décrits dans ce qui suit.

### Exemple 1 : Réalisation de structures multicouches et de feuilles selon les étapes a/ à c/ du procédé selon l'invention.

Plusieurs structures multicouches ont été réalisées en reproduisant l'étape a/ du procédé selon l'invention, à partir de substrats en papier (papiers Bristol et Maine gloss de la société Arjowiggins).

Des tests ont été réalisés pour déterminer les colles les plus appropriées pour la réalisation de l'étape b/ du procédé. La colle utilisée doit assurer une fixation suffisante du papier sur la couche en regard de la structure multicouche, pour éviter qu'il se détache de cette couche lors du retrait du film plastique à l'étape c/.

Nous avons testé trois types de colle : a/ une colle PU bi-composant avec solvant (référence AD 1048 de la société Rexor), b/ une colle PU mono-composant avec solvant (référence NC 320 de la société COIM), et c/ une colle PU mono-composant sans solvant (référence SF2930 de la société COIM).

Des tests ont été réalisés au moyen d'un ruban adhésif pour déterminer le niveau d'adhésion des papiers sur les structures multicouches. Les meilleurs résultats ont été obtenus lorsque la colle PU était appliquée sur la structure multicouche plutôt que sur le papier, lorsque la colle a/ était utilisée pour coller le papier Bristol et lorsque la colle b/ était utilisée pour coller le papier Maine gloss.

### Exemple 2 : Préparation d'une feuille comportant un film mince d'or qui est formé in situ sur la couche de base de la feuille (procédé avec étape d1/).

Le dépôt d'un film d'or sur la couche de base d'une feuille obtenue par le procédé selon l'invention, est réalisé sous vide au moyen d'une machine DEP280. Cette machine permet de déposer sous vide de nombreux métaux tels que du titane, du cuivre ou bien de l'or. Dans le cas présent, une fine couche d'or est déposée sur la couche de base de la feuille. Auparavant, la feuille est mise à l'étuve pour être dégazée (100°C). Ainsi, la pression diminue. La pression dans l'enceinte s'élève à 9,5.10⁻⁷ mbar (pendant environ 14 minutes) et à 8.10⁻⁷ mbar (pendant environ 25 minutes). Une pré-pulvérisation a lieu tout d'abord durant 120 secondes. Suit une pulvérisation pendant 375 secondes. Le dépôt d'or sur la feuille au final est de 30nm d'épaisseur. Il est possible de placer jusqu'à trois feuilles à traiter simultanément dans la machine.

### Exemple 3 : Réalisation d'une étape de photolithographie à partir d'une feuille revêtue d'une couche métallique, telle que celle obtenue à l'exemple 2.

Une résine positive de 1,8µm d'épaisseur (représentant environ 2mL de résine) est déposée par spin-coating sur un échantillon (dimensions 11*11cm) de feuille revêtue d'une couche métallique, telle que celle obtenue à l'exemple 2, par rotation à une vitesse de 3000rpm. Cette opération dure environ 15 secondes. La différence entre une résine positive et une résine négative se fait lors du développement des zones soumises au rayonnement de photolithographie (insolation). Dans le premier cas, ce sont les zones insolées qui disparaissent lors du développement ; dans le deuxième cas, ce sont les zones non-insolées.

La feuille est placée à l'étuve pour réticulation de la résine. Ceci se fait à une température de 115°C et pendant une durée de 5 minutes environ. Pour l'étape d'insolation, un masque en quartz est disposé sur la feuille, ce masque comportant des motifs, et les rayons étant destinés à passer qu'au niveau des zones où il n'y a pas de motif.

L'insolation est réalisée à une puissance de 5mW et dure 10 secondes. Ce temps dépend de l'épaisseur de résine déposée et de la puissance du rayonnement. Une fois cette étape terminée, le masque est nettoyé à l'acétone. La phase de développement peut alors avoir lieu. Un produit appelé tétra-méthylammonium hydroxyde (MF-319) sert de développeur après insolation. Cette étape dure une minute. Cela permet de faire apparaître les motifs à l'oeil nu sur la feuille. Comme il s'agit ici d'une résine positive, le développeur retire la résine insolée. La feuille est placée ensuite dans un bain de gravure pour retirer la résine insolée restée sur la couche métallique. On utilise un mélange de potassium-iodure/iode (KI/I₂). Cette étape dure vingt secondes. Après un rinçage à l'eau, il ne reste alors que la couche métallique et la résine non-insolée. La feuille est recuite à 115°C pendant quelques minutes dans le but de retirer l'eau au maximum. La résine est ensuite retirée de la couche métallique par stripping. Pour cela, l'échantillon est trempé dans un bain d'acétone pendant quinze minutes avec des ultrasons pour retirer la résine résiduelle.

La feuille a une très bonne stabilité thermique et n'est pas altérée par les traitements thermiques successifs.

Exemple 4 : Réalisation d'une étape d'ablation laser d'une couche métallique déposée sur une feuille, telle que celle obtenue à l'exemple 2.

L'ablation laser peut être réalisée au moyen d'une machine Tamarack Scientific. Un laser vient ablater des zones définies par un opérateur. La couche métallique (tel que de l'or) qui subit la contrainte du laser commence par absorber le choc, puis la chaleur de celui-ci se propage. Une différence de dilatation se crée à cause de ce phénomène, ce qui entraîne l'ablation définitive du métal. Cette technique d'ablation est soustractive et de type « *direct patterning ».* Cela signifie que le dessin est réalisé sans ajout de produit. Ici, c'est le faisceau laser qui passe à travers un masque et vient arracher la matière de son support. La puissance du faisceau est réglée en fonction du matériau et de la quantité de matière à prélever. Les résultats finaux après ablation laser des matériaux dépendent de l'influence de la nature et des propriétés thermiques et mécaniques des matériaux.

Les essais ont révélés de bonnes tenues thermique et mécanique de la feuille à l'ablation laser et une bonne définition des motifs créés par laser.

### Exemple 5 : Exemple de fabrication d'un composant électronique à partir des feuilles obtenues aux exemples 3 et 4

Les couches métalliques des feuilles obtenues aux exemples 3 et 4 ont été revêtues d'une couche d'un matériau diélectrique, puis ces couches diélectriques ont été elles-mêmes revêtues d'une couche fine d'argent pour réaliser des capacités.

D'autres couches métalliques des feuilles obtenues aux exemples 3 et 4 ont été imprimées avec une encre carbonée pour la réalisation de résistances.

### Exemple 6 : Exemple de fabrication de feuilles comportant chacune une couche de base imprimable.

Le procédé selon l'invention est utilisé pour fabriquer des feuilles comportant chacune une couche de base qui est imprimable, en particulier avec des encres ayant des propriétés électriques.

Trois couchages papetiers différents ont été utilisés, qui sont respectivement identifiés pas les lettres A, B et C. Ce sont des couches à base de carbonates de calcium broyés très fin (commercialisés sous la marque *Carbital 95*) et de liants. Les autres produits de chaque couche servent à régler la viscosité, à réticuler le liant ou à favoriser l'étalement de la couche.

La différence entre les couches A, B et C est principalement leur taux de liant, qui est de 16,2% pour la couche A, de 8,8% pour la couche B, et de 16,2% pour la couche C (dont 8,1% de liant et 8,1% de co-liant ou promoteur d'adhésion), en poids sec par rapport au poids total sec (ou poids total de matière sèche) de la couche.

Les compositions de ces couches sont détaillées dans le tableau suivant.

| Composants | Couche A | | Couche B | | Couche C | |
|---|---|---|---|---|---|---|
| | Poids humide | Poids sec | Poids humide | Poids sec | Poids humide | Poids sec |
| Eau | 502,273 | 0,000 | 60,724 | 0,000 | 39,177 | 0,000 |
| Ammoniaque Alacali 20 % | 2,623 | 0,000 | 0,317 | 0,000 | 0,205 | 0,000 |
| Dispex N40 | 2,623 | 1,705 | 0,317 | 0,206 | 0,205 | 0,133 |
| Sel fin épuré séché | 2,914 | 2,914 | 0,352 | 0,352 | 0,227 | 0,227 |
| Calgon PTH | 0,058 | 0,029 | 0,007 | 0,004 | 0,005 | 0,002 |
| Empicol LZ | 0,058 | 0,029 | 0,007 | 0,004 | 0,005 | 0,002 |
| Defoamer 1512M | 0,204 | 0,102 | 0,025 | 0,012 | 0,016 | 0,008 |
| Aqnique EHS 75E | 2,331 | 1,247 | 0,282 | 0,151 | 0,182 | 0,097 |
| Surfinol 420 | 0,729 | 0,342 | 0,088 | 0,041 | 0,057 | 0,027 |
| Carbital 95 78 % | 474,565 | 727,366 | 57,374 | 87,937 | 37,016 | 56,734 |
| Stvronal D517 | 190,617 | 97,215 | 11,519 | 5,875 | 7,432 | 3,790 |
| Acronal S305 | 94,066 | 48,444 | 5,683 | 2,927 | 3,666 | 1,888 |
| AZC | 29,141 | 19,816 | 3,523 | 2,396 | 2,273 | 1,546 |
| Sterocoll FD | 1,311 | 0,688 | 0,159 | 0,083 | 0,102 | 0,054 |
| Defoamer 1512M | 0,204 | 0,102 | 0,025 | 0,012 | 0,016 | 0,008 |
| Diamond | 0,000 | 0,000 | 0,000 | 0,000 | 28,392 | 5,678 |
| Poids total sec (Kg) | 900 | | 100 | | 70 | |
| Poids total humide (Kg) | 1303 | | 140 | | 119 | |
| Taux de liant (par rapport au poids total de matière sèche) | 16,2% en poids sec | | 8,8% en poids sec | | 16,2% en poids sec | |
| Taux de liant (par rapport au poids sec des pigments) | 20% en poids sec | | 10% en poids sec | | 20% en poids sec | |

L'Ammoniaque Alcali 20% est une solution aqueuse. Le Dispex N40 est un polyacrylate anionique qui sert de dispersant et d'émulsionnant en solution. Le Calgon PTH est un phosphate qui sert de dispersant en poude. L'Empicol LZ est un agent mouillant sous forme de poudre. L'Agnique EHS 75E est un agent mouillant liquide. Le Surfinol 420 sert d'antimousse, de dispersant et d'agent mouillant. Le Carbital 95 78% représente des pigments de carbonates de calcium en milieu liquide. Le Styronal D517 et l'Acronal S305 sont des latex formant des liants. Le Styronal D517 est un latex de styrène-butadiène et l'Acronal S305 est un butyl-acrylate/styrène (styrène acrylique). AZC (ammonium-zirconium carbonate) est un agent d'insolubilisation liquide. Le Sterocoll FD est un acide acrylique qui sert d'agent modificateur de rhéologie. Le Defoamer 1512 M est un antimousse liquide et le Diamond est un co-liant ou promoteur d'adhérence à base d'un copolymère éthylène - acide acrylique (EAA)

Plusieurs papiers commercialisés par la société Arjowiggins ont été utilisés pour fabriquer des feuilles avec le procédé selon l'invention. Chaque feuille comprend une couche imprimable (A, B ou C) ou deux couches imprimables superposées (A+A, A+B ou A+C). Dans le cas d'une feuille à deux couches imprimables, une première couche A est déposée sur la colle et se retrouve donc en dessous de la seconde couche ou couche externe (A, B ou C) dans le produit final.

Deux films plastiques PET, utilisés comme donneur dans le procédé, ont été testés. Le premier est un film PET standard et le second est un film PET plus lisse (référencé 42).

Le tableau suivant résume les caractéristiques des différentes feuilles réalisées par le procédé selon l'invention.

Des tests d'impression par jet d'encre à effet piézoélectrique au moyen d'une machine Dimatix de Fujifilm et par sérigraphie ont été réalisés. Deux types d'encre ont été utilisés (Sunjet U5603 et SICPA 9SP7214), à base de nanoparticules d'argent.

La couche de base d'une feuille peut être imprimée par une couche d'encre puis soumise à une étape de recuit, avant d'être à nouveau imprimée avec une nouvelle couche d'encre et soumise à une autre étape de recuit. Dans ce cas, après la première étape de recuit, la feuille peut être stockée dans un endroit appropriée et/ou soumise à un traitement particulier, afin qu'elle récupère son taux d'humidité initial (avant recuit), avant d'être à nouveau imprimée.

| Essai n° | Papier | Epaisseur du papier (mm) | Grammage (g/ₘ₂) | Type de couche | Couche(s) | Film plastique (donneur) | Type d'impression | Référence de l'encre utilisée | Nombre de couches d'encre | Mode de recuit | Température de recuit (°C) | Temps de recuit (min) | Rmoyenne (Ω/square) |
|---|---|---|---|---|---|---|---|---|---|---|---|---|---|
| 1 | Maine gloss 2858 offset chambre chaude | 117 | 135 | poreuse | B | PET standard | Jet d'encre | Sunjet U5603 | 2 | Sécheur IR | 150 à 200 | 3 | 0,588 |
| 2 | Maine gloss 2933 offset chambre chaude | 111 | 135 | poreuse | A+B | PET 42 | Jet d'encre | Sunjet U5603 | 2 | | | | 3,41 |
| 3 | Maine 135 offset base | 102 | 191 | poreuse | sans | | Jet d'encre | Sunjet U5603 | 2 | | | | 0,287 |
| 4 | Maine 2934 indigo sans chambre chaude | 111 | 135 | fermée | A+C | PET 42 | Jet d'encre | Sunjet U5603 | 2 | | | | 0,051 |
| 5 | Bristol 2932 électronique chambre chaude | 205 | 200 | fermée | A+A | PET 42 | Jet d'encre | Sunjet U5603 | 1 | | | | 0,3 |
| 6 | Maine gloss 2947 électronique chambre chaude | 113 | 135 | fermée | A+A | PET 42 | Jet d'encre | Sunjet U5603 | 1 | | | 2 | 0,3 |
| 7 | Maine gloss 2947 électronique chambre chaude | 113 | 135 | fermée | A+A | PET 42 | Jet d'encre | Sunjet U5603 | 2 | | | 3 | 0,07 |
| 8 | Bristol 2828 électronique 1 couche | 275 | 250 | fermée | A | PET standard | Sérigraphie | SICPA 9SP7214 | 1 | Pas de recuit | Pas de recuit | 3 | 0,084 |
| 9 | Bristol 2828 électronique 1 couche | 275 | 250 | fermée | A | PET standard | Sérigraphie | SICPA 9SP7214 | 1 | Etuve | 165 | 3 | 0,078 |
| 10 | Bristol 2828 électronique 2 couches | 275 | 250 | fermée | A+A | PET standard | Sérigraphie | SICPA 9SP7214 | 2 | Pas de recuit | Pas de recuit | 3 | 0,244 |
| 11 | Bristol 2828 électronique 2 couches | 275 | 250 | fermée | A+A | PET standard | Sérigraphie | SICPA 9SP7214 | 2 | Etuve | 165 | 3 | 0,078 |
| 12 | Maine 2828 électronique 1 couche | 64 | 80 | fermée | A | PET standard | Sérigraphie | SICPA 9SP7214 | 1 | Pas de recuit | Pas de recuit | 3 | 0,126 |
| 13 | Maine 2828 électronique 1 couche | 64 | 80 | fermée | A | PET standard | Sérigraphie | SICPA 9SP7214 | 1 | Etuve | 165 | 3 | 0,074 |
| 14 | Maine 2828 électronique 2 couches | 64 | 80 | fermée | A+A | PET standard | Sérigraphie | SICPA 9SP7214 | 2 | Pas de recuit | Pas de recuit | 3 | 0,322 |
| 15 | Maine 2828 électronique 2 couches | 64 | 80 | fermée | A+A | PET standard | Sérigraphie | SICPA 9SP7214 | 2 | Etuve | 165 | 3 | 0,144 |
| 16 | PEN Teonex Q65FA125 | 122 | | | | | Jet d'encre | Sunjet U5603 | 2 | Sécheur IR | 150 à 200 | 2,5 | 0,141 |

Les résistances des couches d'encre doivent être les plus faibles possibles. On constate que le nombre d'impression d'un papier a une influence sur sa résistance. Plus le papier comporte de couches d'encres et plus sa résistance est faible. Lorsque l'on compare les essais 3, 4 et 7 concernant des papiers revêtus de deux couches d'encre, on constate que les couches fermées des essais 4 et 7 ont une résistance plus faible que la couche poreuse de l'essai 3. Les feuilles comportant une couche externe fermée (A ou C) présentent de bons résultats en termes de résistance. Au contraire, chaque feuille ayant une couche B, qui est une couche poreuse ou ouverte, ne présente pas de bons résultats à ce sujet (voir les deux premiers essais).

On peut expliquer ceci par le fait que les couches poreuses permettent à l'encre de s'absorber dans la feuille, la couche d'encre n'étant alors pas continue en surface.

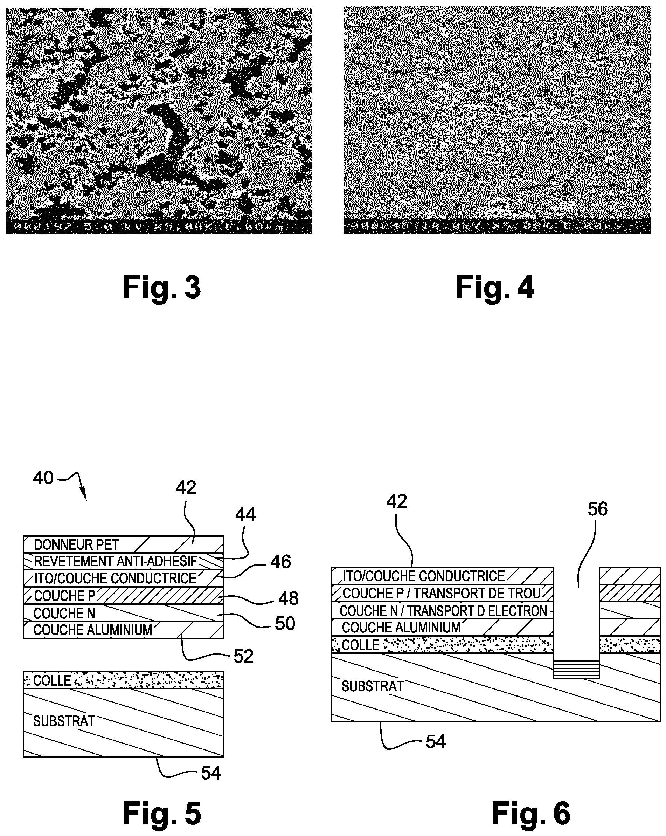

Ces différences de porosité entre les feuilles sont nettement visibles aux figures 3 et 4 qui représentent des photographies MEB des surfaces à imprimer des feuilles Maine gloss 2858 (feuille poreuse ou ouverte - premier essai) et Maine 2828 (feuille fermée ou non poreuse - essais 12 à 15), respectivement.

On peut caractériser la porosité d'une couche par son taux de liant et on peut la mesurer en réalisant un test aux encres porométriques.

Le test aux encres porométriques permet de mesurer la capacité d'absorption d'une feuille et la vitesse de pénétration de l'encre, par la dépose d'une encre spéciale (comportant un colorant noir) sur cette feuille et par l'étude de son comportement au cours du temps. Ce test permet en outre d'apprécier l'évolution de la densité optique d'une feuille après impression.

L'encre utilisée est ici une encre porométrique de la société Lorilleux, commercialisée sous la référence 3809. Il s'agit d'un vernis dans lequel a été dissous un faible pourcentage de colorant noir.

La feuille est fixée sur un plan de travail propre et lisse grâce à du ruban adhésif. Un tampon métallique en bronze, de diamètre 2,4mm et de masse égale à 328g, préalablement encré (fine pellicule), vient déposer un macaron d'encre sur la surface à tester. Après un laps de temps de contact évalué au chronomètre (t = 0, 7, 15, 30, 60 et 120s), l'excédent d'encre est complètement essuyé à l'aide d'un chiffon (de préférence doux et non pelucheux). Il est impératif que l'opération soit réalisée en un seul mouvement, dans une seule direction, avec fermeté afin d'éviter de laisser des résidus sur l'empreinte. Ce mouvement génère ainsi, derrière lui, une autre empreinte nette en forme de traînée de comète.

L'encre, en pénétrant dans la feuille, teinte plus ou moins sa surface suivant la quantité d'encre absorbée. On mesure la densité optique des taches sur la feuille avec un densimètre à réflexion. On peut ainsi apprécier l'évolution de la densité optique en fonction du temps de pénétration de l'encre et avoir une indication globale sur la vitesse et la capacité d'absorption de la feuille.

Le tableau suivant montre l'évolution de la densité optique des encres déposées sur les couches de base imprimables de plusieurs feuilles obtenues par le procédé selon l'invention, en fonction du temps écoulé (en secondes) après le dépôt de l'encre sur ces couches.

| Essai n° | Papier | t = 0s | t = 7s | t = 15s | t = 30s | t = 60s | t = 120s |
|---|---|---|---|---|---|---|---|
| 12 à 15 | Maine 2828 | 0,08 | 0,1 | 0,09 | 0,1 | 0,1 | 0,1 |
| 17 | Opale 2858 | 0,15 | 0,17 | 0,23 | 0,27 | 0,32 | 0,4 |
| 8 à 11 | Bristol 2828 | 0,08 | 0,09 | 0,09 | 0,1 | 0,09 | 0,11 |
| 1 | Maine mono composant 2858 | 0,13 | 0,14 | 0,17 | 0,2 | 0,26 | 0,32 |
| 18 | Stoneywood 2935 | 0,08 | 0,09 | 0,11 | 0,1 | 0,1 | 0,1 |
| 19 | Papier Chromolux 300 | 0,18 | 0,21 | 0,21 | 0,31 | 0,39 | 0,56 |
| 20 | Papier Chromolux 180 | 0,13 | 0,16 | 0,17 | 0,26 | 0,32 | 0,44 |
| 21 | Bristol 2930 chambre chaude | 0,18 | 0,19 | 0,21 | 0,27 | 0,32 | 0,33 |
| 22 | Bristol 2931 chambre chaude | 0,14 | 0,14 | 0,18 | 0,16 | 0,2 | 0,19 |
| 5 | Bristol 2932 chambre chaude | 0,05 | 0,06 | 0,06 | 0,08 | 0,08 | 0,09 |
| 2 | Maine gloss 2933 chambre chaude | 0,21 | 0,22 | 0,27 | 0,28 | 0,32 | 0,37 |
| 4 | Maine indigo 2934 chambre chaude | 0,12 | 0,14 | 0,13 | 0,18 | 0,18 | 0,15 |
| 6 | Maine gloss 2947 chambre chaude | 0,09 | 0,09 | 0,09 | 0,09 | 0,11 | 0,12 |
| 3 | Maine base | 0,26 | 0,3 | 0,3 | 0,34 | 0,4 | 0,47 |

Une couche fermée se caractérise par une faible densité d'encre à Os et aucune ou peu d'évolution de cette densité dans le temps. A contrario, une couche poreuse aura dès le départ une plus forte densité et surtout une augmentation de la densité dans le temps.

On constate que les feuilles à couche de base poreuse (essais 1 à 3 et 17 à 21) ne présente pas de bons résultats (variation importante de la densité optique des encres au cours du temps) au contraire des feuilles à couche de base fermée (essais 4 à 15 et 22).

Il est donc important d'utiliser des feuilles ayant chacune une couche de base imprimable. Dans le cas de couche de base imprimable, cette porosité est, comme expliqué dans ce qui précède, maîtrisée par le taux de liant de la couche de base qui doit, selon l'invention, être supérieur à 15% en poids sec par rapport au poids sec de la couche. Aucune différence n'a été constatée pour le type de film utilisé pour le donneur.

### Exemple 7 : Evaluation de la porosité de surface de feuilles obtenues par le procédé selon l'invention, par mesure de la fraction ouverte des surfaces de ces feuilles déterminée par analyse d'images.

Des images MEB telles que celles obtenues dans l'exemple 6 et représentées aux figures 3 et 4 ont été analysées pour mesurer la fraction surfacique des pores à la surface des couches de base des feuilles. On a constaté que les fractions surfaciques de porosité des feuilles sont très variables.

| Essai n° | Papier | Taux de liant(s) en % (poids sec) | Fraction ouverte (%) |
|---|---|---|---|
| 8 à 15 | 2828 | 16,2 | 0,08 |
| 1 | 2858 | 8,8 | 4,3 |
| 21 | 2930 | 8,8 | 5,27 |
| 22 | 2931 | 8,1 + 8,1 Diamond | 1,55 |
| 2 | 2933 | 8,8 | 1,88 |
| 4 | 2934 | 16,2 | 0,81 |
| 6à7 | 2947 | 16,2 | 0,19 |

Nous constatons en premier lieu que les surface ouvertes sont toutes relativement faibles (< 6%). Il y a une forte influence du taux de liant sur la fraction ouverte des feuilles. En effet, les feuilles avec un taux de liant de 16,2% en poids sec ou plus ont une fraction ouverte inférieure ou égale à 1,55% alors que les papiers avec un taux de liant de 8,8% en poids sec ou moins ont une fraction ouverte supérieure ou égale à 1,88 %. De plus, si l'on exclue la feuille 2931 (essai n °22), qui a 8,1 % de liant et 8,1 % de co-liant (Diamond), les résultats sont encore plus probants.

Le tableau ci-dessous résume l'influence du taux de liant sur les propriétés des feuilles testées.

| Essai n° | Papier | Taux de liant(s) en % (poids sec) | Fraction ouverte (%) | Densité des encres porométriques | | | Résistance encre argent (Ω/sq) |
|---|---|---|---|---|---|---|---|
| | | | | 0s | 120s | Delta 120-0 | |
| 8-15 | 2828 | 16,2 | 0,08 | 0,08 | 0,1 | 0,02 | |
| 1 | 2858 | 8,8 | 4,3 | 0,15 | 0,4 | 0,25 | 0,59 |
| 21 | 2930 | 8,8 | 5,27 | 0,18 | 0,33 | 0,15 | |
| 22 | 2931 | 8,1 + 8,1 Diamond | 1,55 | 0,14 | 0,19 | 0,05 | |
| 2 | 2933 | 8,1 | 1,88 | 0,21 | 0,37 | 0,16 | 3,41 |
| 4 | 2934 | 16,2 | 0,81 | 0,12 | 0,15 | 0,03 | 0,051 |
| 6-7 | 2947 | 16,2 | 0,19 | 0,09 | 0,12 | 0,03 | 0,07 |

Les feuilles ayant des couches avec des taux de liant de 8,8% (en poids sec) ont des surfaces poreuses, puisque la fraction ouverte de ces surfaces est forte (au moins de 1,88%), ce qui provoque une forte absorption des liquides comme les encres porométriques. Ainsi, la différence de densité optique des encres entre 120s et 0s est supérieure à 0,1 pour ces feuilles à couches poreuses, alors que pour les feuilles ayant des couches avec un taux de liant de 16,2% (en poids sec), la fraction ouverte est faible et la différence de densité optique entre 120s et 0s pour le test aux encres pyrométriques est faible (inférieure à 0,1).

Lorsque l'on imprime ces feuilles avec des encres comportant des nanoparticules d'argent, par un procédé par jet d'encre, puis que l'on soumet ces feuilles à un recuit thermique d'environ 150°C, nous trouvons que la résistance des pistes imprimées est également liée au taux de liant des feuilles.

Les feuilles avec des couches ayant un fort taux de liant, donc avec une couche fermée, donnent des pistes imprimées qui sont peu résistives (respectivement de 0,13Ω/sq et 0,07Ω/sq pour les papiers 2934 et 2947 - essais 4 et 6-7). Une valeur de 0,15Ω/sq ou inférieure est considérée comme bonne pour des films plastiques en PEN imprimés.

Dans les mêmes conditions, les feuilles avec des couches ayant un faible taux de liant, donc avec des couches relativement ouvertes, donnent des pistes imprimées qui sont plus résistantes (respectivement de 0,59Ω/sq et de 3,4Ω/sq). On peut expliquer ceci par le fait que les encres conductrices pénètrent dans les pores de surface des feuilles et créent des défauts dans les pistes qui font augmenter leur résistivité.

Nous pouvons donc en conclure que le taux de liant influence fortement l'aptitude à l'impression de ces papiers par des encres ayant des propriétés électriques.

### Exemple 8 : Réalisation de feuilles à couches de base imprimables, à partir de différents pigments.

Des tests complémentaires ont été réalisés pour déterminer d'une part l'influence du type de pigments et du taux de liant dans la couche de base imprimable, sur le transfert réalisé aux étapes b/ et c/ du procédé.

Plusieurs structures multicouches ont été préparées selon l'étape a/ du procédé, chacune de ces structures comportant une couche de base imprimable.

Le tableau ci-dessous récapitule les différents pigments utilisés dans les couches de base des feuilles ainsi que le taux de liant de chacune de ces couches. Treize structures multicouches différentes ont été préparées (A à M).

| | | | | Test aux encres porométriques | | | | |
|---|---|---|---|---|---|---|---|---|
| Essai | Charges | Taux de liant [%] | Brillance à 75°[%] | 0s | 7 s | 15 s | 60 s | 120 s |
| A | Kaolin | 9,1% | 8 | 1 | 1,2 | 1,3 | 1,4 | 1,4 |
| B | | 16,7% | 26 | 0,3 | 0,78 | 1,15 | 1,4 | 1,4 |
| C | | 23,1% | 44 | 0,25 | 0,45 | 0,8 | 1;1 | 1,1 |
| D | Carbonates de calcium | 9,1% | 42 | 0,19 | 0,35 | 0,37 | 0,46 | 0,55 |
| E | | 16,7% | 87 | 0,06 | 0,07 | 0,07 | 0,11 | 0,14 |
| F | | 23,1% | 93 | 0,05 | 0,07 | 0,08 | 0,07 | 0,07 |
| G | Charges plastique | 9,1% | 17 | | | | | |
| H | | 16,7% | 36 | 0,46 | 0,53 | 0,65 | 0,3 | 0,3 |
| I | | 23,1% | 73 | 0,21 | 0,36 | 0,25 | 0,62 | 0,65 |
| J | Nano TiO2 | 9,1% | 4 | | | | | |
| K | | 16,7% | 85 | | | | | |
| L | | 23,1% | 92 | 0,2 | 0,3 | 0,4 | 0,62 | 0,78 |
| M | Sans charge | 100% | 103 | 0,07 | 0,07 | 0,07 | 0,07 | 0,07 |

Le Kaolin est celui commercialisé par la société Golden Rock Kaolin sous la dénomination Kaolin SC 90. Le carbonate de calcium est celui commercialisé par la société Imerys sous le nom Carbital 95. Les charges plastiques sont commercialisées par la société Rhom & Haas sous l'appellation Ropaque Ultra E et les nanoparticules de dioxyde de titane sont commercialisées par la société Kemira sous la référence US Titan L181.

On a constaté que chaque structure multicouche comportant une couche de base ayant un taux de liant inférieur à 15% n'était pas correctement transférée sur le substrat papier lors des étapes b/ et c/ du procédé. Par ailleurs, de meilleurs résultats de transfert ont été obtenus avec des couches de base dont les pigments sont des charges minérales plutôt que des charges plastiques. Les meilleurs résultats ont été obtenus avec les couches de base dont les pigments sont des carbonates de calcium car ces couches sont très brillantes (et donc lisses) et sont fermées (valeurs de densité optiques relativement faibles et constantes au cours du temps). La couche de base ne comportant pas de charge a également l'avantage d'avoir une forte brillance et également de définir une surface fermée.

### Exemple 9 : Réalisation d'une feuille électro-conductrice embossée, pour la réalisation d'un transistor par exemple.

La figure 5 représente une structure multicouche 40 réalisée par le procédé selon l'invention, cette structure multicouche 40 comprenant un film plastique 42 en PET sur une face duquel sont superposées les couches suivantes : un revêtement antiadhésif 44, une couche électro-conductrice 46 en ITO (oxyde d'étain-indium), une couche 48 en matériau semi-conducteur dopé P, une couche 50 en matériau semi-conducteur dopé N, et une couche d'aluminium 52. Cette structure est obtenue à l'issue de l'étape a/ du procédé.

Cette structure multicouche 40 est ensuite collée sur un substrat 54 en papier (étape b/), puis le film plastique 42 est retiré mettant à nue la couche électro-conductrice 46 en ITO (étape c/). On obtient ainsi une feuille électro-conductrice pouvant être utilisée pour la fabrication de composants électroniques, tels qu'un transistor.

Dans une étape supplémentaire du procédé, la feuille est embossée par une technique appropriée en exerçant des forces de compression sur la couche 46 d'ITO (dans une direction perpendiculaire au plan de la feuille), dans des zones particulières et au moyen d'un technique appropriée connue de l'homme du métier. Cela crée des renfoncements 56, comme représenté en figure 6, au fond desquels sont déplacées des portions des couches 46 à 52, qui restent superposées les unes aux autres.

### Exemple 10 : Réalisation d'une feuille transparente électro-conductrice.

Le procédé selon l'invention a été utilisé pour fabriquer une feuille transparente électro-conductrice, cette feuille comportant un papier calque de 65g/m² et ayant une transparence de 66%. Une couche de base imprimable à base de carbonate de calcium et comportant 50% en poids sec de liant par rapport au poids total de matière sèche de la couche de base est transférée sur le papier calque par le procédé. Le calque obtenu a une transparence de 68,5% et un lissé Bekk supérieur à 10 000s. La feuille transparente a ensuite été imprimée avec des encres ayant des propriétés électriques.

### Exemple 11 : Mesure de la brillance et de la densité optique d'encres imprimées sur des feuilles préparées à partir du procédé selon l'invention.

Plusieurs feuilles ont été préparées par le procédé selon l'invention, ces feuilles se différenciant les unes des autres par le taux de liant de leurs couches de base imprimables (à base de carbonate de calcium), qui varie entre 9,1 et 23,1%.

Le tableau ci-dessous résume les résultats de mesures de brillance et de tests aux encres porométriques effectuées sur six feuilles.

| Essais | Taux de liant | Brillance | Test aux encres porométriques | | | | |
|---|---|---|---|---|---|---|---|
| | | | 0s | 7s | 15s | 60s | 120s |
| D | 9,1% | 42 | 0,19 | 0,35 | 0,37 | 0,46 | 0,55 |
| N | 14% | 70 | 0,09 | 0,15 | 0,17 | 0,2 | 0,23 |
| O | 15% | 78 | 0,08 | 0,13 | 0,14 | 0,17 | 0,2 |
| P | 16% | 84 | 0,06 | 0,09 | 0,1 | 0,12 | 0,15 |
| E | 16,7% | 87 | 0,06 | 0,07 | 0,08 | 0,11 | 0,14 |
| F | 23,1% | 93 | 0,05 | 0,07 | 0,08 | 0,07 | 0,07 |

On constate que, au-delà de 15% en poids sec de liant dans la couche de base, la feuille comprend une brillance supérieure à 80 et une densité optique inférieure ou égale à 0,15 à 120s, ce qui signifie que la couche est peu absorbante et ce qui constitue de bons résultats.

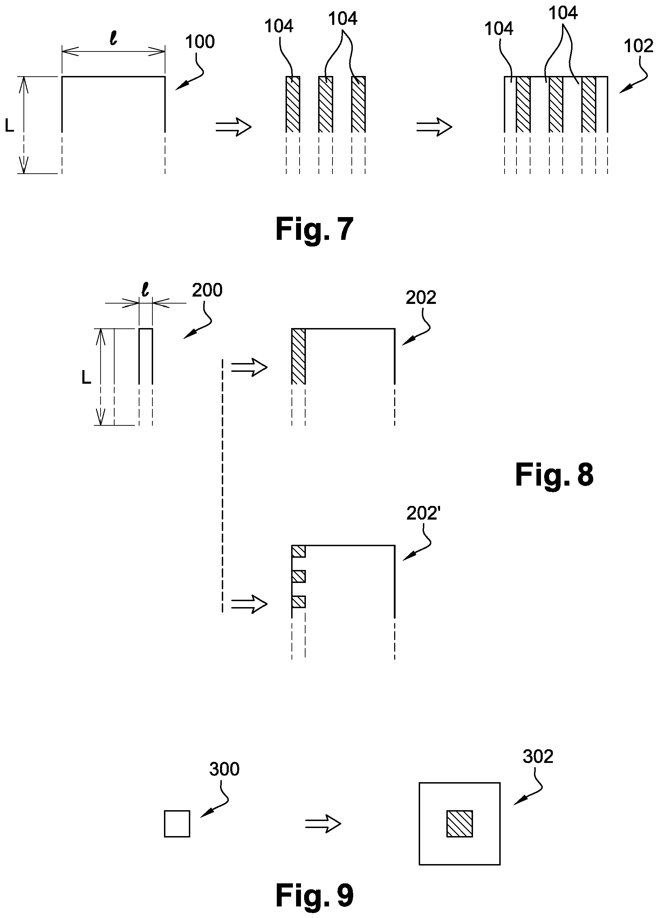

On se réfère maintenant aux figures 7 à 11 qui représentent plusieurs modes de réalisation du procédé selon l'invention pour la fabrication d'une feuille dont au moins une face comporte une zone de plus grand lissé que le reste de cette face, cette zone s'étendant sur une surface inférieure à celle de la face.

Dans le cas de la figure 7, un film plastique 100 ayant des dimensions (largeur I et longueur L) relativement importantes est utilisé, ces dimensions étant par exemple similaires à celles de la feuille ou du papier 102 destiné à recevoir la structure multicouche. Le film plastique est par exemple en PET et a une largeur de 1,5m, une longueur de plusieurs dizaines de mètres et une épaisseur de 5 à 20µm environ.

La structure multicouche est préparée (étape a)) à partir de ce film plastique 100 de grandes dimensions, comme indiqué dans ce qui précède. Cette structure multicouche peut comprendre un revêtement antiadhésif, une couche de base électro-conductrice, une couche de colle et une couche barrière. La structure multicouche est ensuite découpée en bandes 104 dont la longueur est égale à la longueur initiale du film plastique 100 et dont la largeur est par exemple de quelques millimètres ou centimètres.

Une ou plusieurs de ces bandes 104 sont collées sur le papier 102 suivant l'étape b). Dans le cas de la figure 7, le papier 102 reçoit trois bandes 104 qui sont sensiblement parallèles et à distance les unes des autres. Les portions de film plastique de ces bandes 104 peuvent ensuite être retirées selon l'étape c) de façon à révéler des couches de base indépendantes qui définissent des zones lisses et qui forment chacune une couche électro-conductrice ou qui sont chacune destinées à être recouvertes d'une couche électro-conductrice.

Le papier 102 ainsi préparé peut avoir de grandes dimensions et être destiné à être découpé pour fabriquer des papiers de format A4 par exemple. Dans un cas particulier de réalisation de l'invention, le papier 102 est découpé de façon à ce que les bandes 104 s'étendent le long de bords longitudinaux des papiers découpés.

L'exemple de réalisation représenté en figure 7 s'apparente au cas (iii) précité du procédé selon l'invention.

Dans le cas de la figure 8, le film plastique 200 a à l'origine une forme allongée et se présente donc sous la forme d'une bande dont la longueur L peut être similaire à celle du papier 202 destiné à recevoir la structure multicouche, et dont la largeur est nettement inférieure à celle de ce papier et est par exemple de quelques millimètres ou centimètres.

La structure multicouche est préparée (étape a)) à partir de ce film plastique 200 et est ensuite collée sur le papier 202 (étape b)).

Dans le premier cas de la figure 8 (dans le coin supérieur droit), le papier 202 reçoit une bande qui s'étend le long de l'un de ses bords longitudinaux. Ce cas particulier s'apparente au cas (iii) précité du procédé selon l'invention.

Dans le second cas de la figure 8 (dans le coin inférieur droit), le papier 202' reçoit une série de plusieurs portions de bande, qui s'étend le long de l'un des bords longitudinaux du papier. Ce papier 202' peut être obtenu de deux façons. Il peut être obtenu en disposant de la colle sur la structure multicouche ou le papier uniquement dans les zones où des portions de bande doivent être collées (cas (ii) et (iii) du procédé selon l'invention). En variante ou en caractéristique additionnelle, il serait possible d'appliquer une pression de collage sur la bande uniquement dans les zones où des portions de bande correspondantes doivent être collées sur le papier. Cela peut être réalisé par exemple au moyen d'une presse à gaufrer, une presse embosseuse ou un presse pour dorure à chaud, qui permet d'appliquer des pressions locales sur le papier lors de sa fabrication (notamment pour un marquage du papier). Dans le second cas de la figure 8, le papier reçoit trois portions de bande distinctes et séparées l'une de l'autre, qui ont chacune une forme sensiblement en carré ou rectangle.

Le film plastique ou les portions de film plastique peuvent ensuite être retirés selon l'étape c) de façon à révéler des couches de base indépendantes qui définissent des zones de plus grand lissé.

Dans le cas de la figure 9, le film plastique 300 a une forme carrée ou rectangulaire dont les dimensions (I et L) sont inférieures à celles du papier 302 destiné à recevoir la structure multicouche.

La structure multicouche est préparée (étape a)) à partir de ce film plastique 300 et est ensuite collée sur le papier 302 (étape b)), dans son milieu dans l'exemple de la figure 9. Le film plastique peut ensuite être retiré de façon à révéler la couche de base (étape c)).

L'exemple de réalisation représenté en figure 9 s'apparente aux cas (ii) et (iii) précités du procédé selon l'invention.

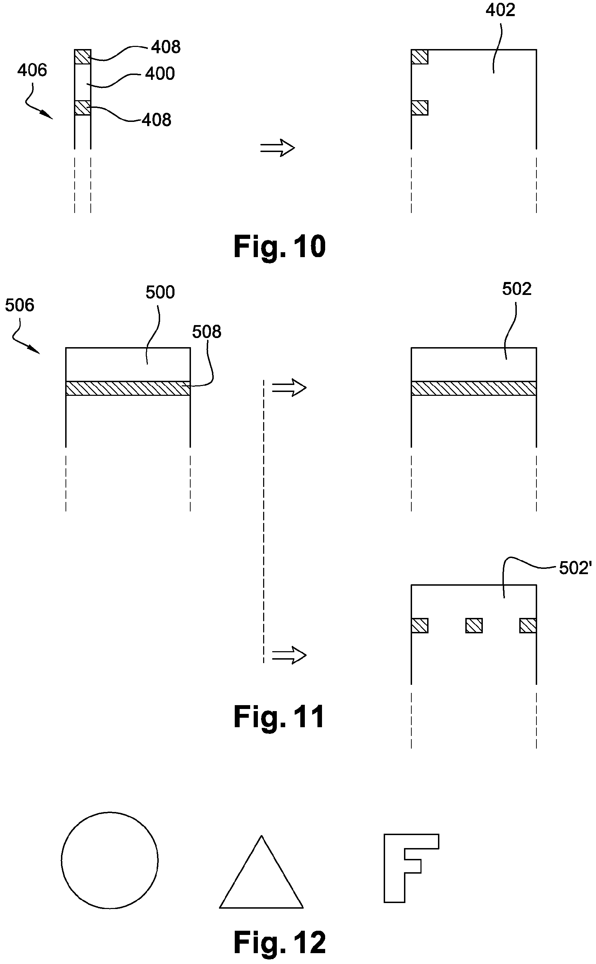

Dans le cas de la figure 10, le film plastique 400 a une forme de bande similaire à celle de la figure 8. La structure multicouche 406 est préparée (étape a)) à partir de cette bande en superposant un revêtement antiadhésif et une couche de base sur des portions 408 seulement de cette bande. La structure multicouche 406 est ensuite collée sur un papier 402 (étape b)) et le film plastique 400 est retiré pour révéler des couches de base distinctes sur le papier 402, comme cela est représenté en figure 10.

L'exemple de réalisation représenté en figure 10 s'apparente aux cas (i) et (iii) précités du procédé selon l'invention.

Dans le cas de la figure 11, le film plastique 500 a une forme similaire à celle de la figure 7. La structure multicouche 506 est préparée (étape a)) à partir de ce film en superposant un revêtement antiadhésif et une couche de base sur une bande 408 seulement de ce film. La structure multicouche 506 est ensuite collée sur un papier 502 (étape b)) et le film plastique 500 est retiré pour révéler une couche de base de forme allongée sur le papier 502, comme c'est le cas dans le premier mode de réalisation représenté dans le coin supérieur droit de la figure 11. Cet exemple de réalisation s'apparente au cas (i) précité du procédé selon l'invention.

Dans la variante représentée dans le coin inférieur droit de la figure 11, le papier 502' reçoit une série de plusieurs portions de bande. Ce papier 502' peut être obtenu comme expliqué dans ce qui précède en relation avec la figure 8. Le film plastique peut ensuite être retiré selon l'étape c). Cet exemple de réalisation peut s'apparenter aux cas (i) et (ii) précités du procédé selon l'invention.

Comme cela est schématiquement représenté en figure 12, la couche de base et/ou la couche électro-conductrice de la feuille préparée par le procédé selon l'invention peut avoir une forme quelconque telle qu'une forme géométrique (rond, triangle, etc.) ou une forme de lettre (« F » dans l'exemple représenté). Cette forme peut être imposée par la forme du film plastique utilisé (lors de la préparation de la structure multicouche), de la structure multicouche utilisée (éventuellement après découpe), de la zone de la structure multicouche ou du substrat sur laquelle est déposée de la colle, et/ou des zones d'appui de la presse utilisée pour contrecoller la structure multicouche et le substrat.

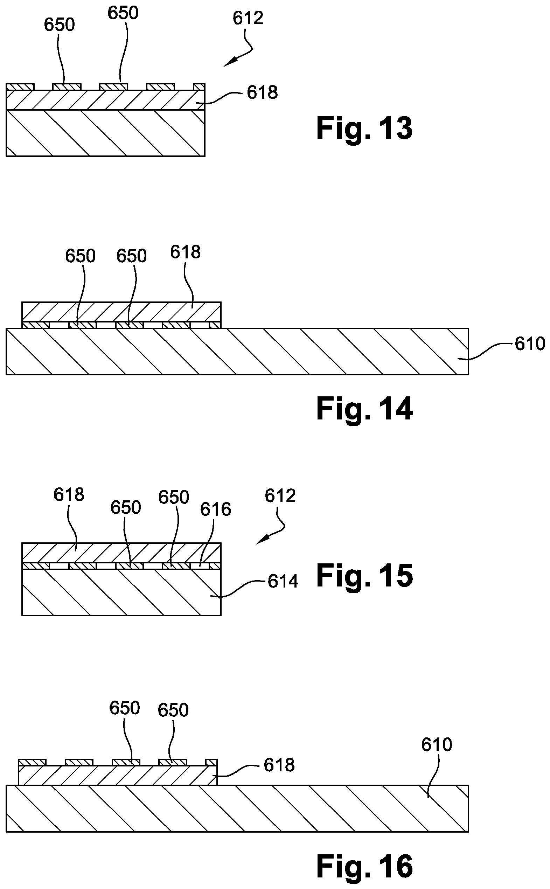

Les figures 13 et 14 représentent une autre variante du procédé selon l'invention dans laquelle la face libre de la couche de base 618 de la structure multicouche 612 est imprimée avec des encres électro-conductrices 650 ou est recouverte d'un revêtement électro-conducteur. Cette face imprimée ou revêtue est ensuite encollée et appliquée sur une face d'un substrat d'une feuille 610. La structure multicouche 612 peut être découpée avant l'étape de contre-collage.

Les figures 15 et 16 représentent une autre variante du procédé selon l'invention dans laquelle le revêtement antiadhésif 616 déposé sur le film plastique 614 de la structure multicouche est imprimé avec des encres électro-conductrices 650 ou est recouvert d'un revêtement électro-conducteur, avant que la couche de base 618 ne soit déposée. La couche de base et cette couche électro-conductrice (encres ou revêtement) sont ensuite transférées sur le substrat de la feuille 610.

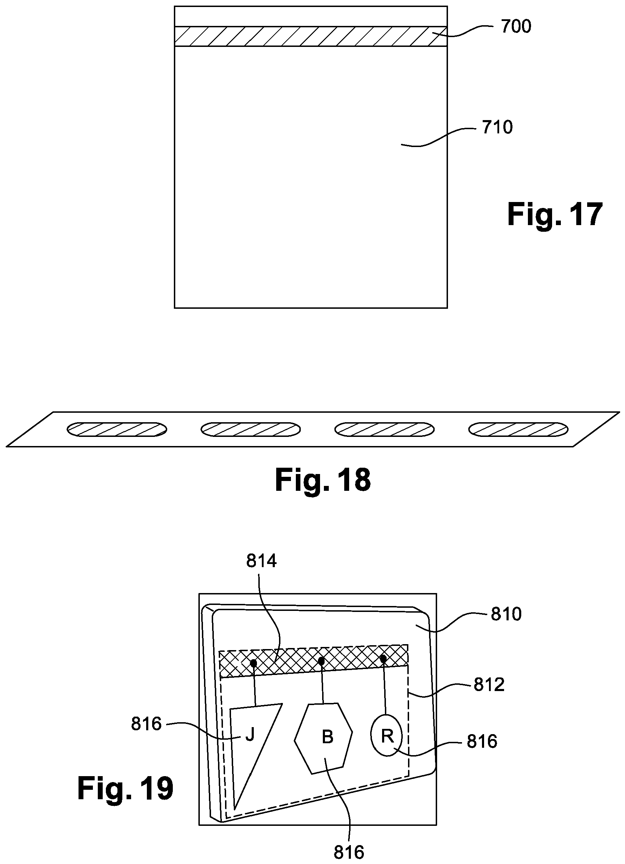

La figure 17 représente une feuille préparée par le procédé selon l'invention dans le cas (iv) précité, c'est-à-dire dans le cas où la couche de base est transférée sur le substrat d'une première feuille, de préférence lisse, qui est destinée à être découpée (en bande 700 dans l'exemple représenté) et à être collée sur le substrat d'une autre feuille 710.

La figure 18 représente une autre feuille préparée par le procédé selon l'invention, en forme de bande. Le substrat de cette feuille est formé par un papier recouvert d'un revêtement antiadhésif ou par un film plastique. Le film plastique ou le revêtement antiadhésif est ici recouvert de quatre zones distinctes de plus grand lissé, c'est-à-dire de quatre zones comportant une couche de base lisse qui est électro-conductrice ou qui est associée ou destinée à être associée à une couche électro-conductrice. Cette feuille est particulièrement adaptée pour fabriquer des étiquettes électroniques.

La figure 19 représente une autre feuille préparée par le procédé selon l'invention. Cette feuille 810 comporte une zone 812 de plus grand lissé préparée de la façon décrite dans ce qui précède. Une partie de cette zone 812 est recouverte par une couche électro-conductrice 814 sur laquelle sont déposées des micro-diodes telles que celles décrites dans le document WO2012/031096, et d'autres parties distinctes de la zone 812 sont recouvertes par des couches 816 de polymère colorées (respectivement jaune (J), bleu (B) et rouge (R)) formant chacune un guide d'onde en contact ou relié à la couche 814 par au moins une bande de même matériau polymère de que la couche considérée. Lorsque la couche électro-conductrice 814 est alimentée par un courant électrique, les micro-diodes émettent un rayonnement lumineux qui est transmis aux couches 816 de polymère qui diffusent elles-mêmes des lumières colorées.

### Exemple 12 : Evaluation de la diffusivité thermique de feuilles.

Des feuilles ont été testées afin de déterminer leur diffusivité thermique en surface (en XY) et en profondeur ou dans la masse (en Z).

Les premiers tests ont été réalisés sur les feuilles suivantes :
- 3382 : feuille Powercoat® (épaisseur 230 µm) commercialisée par la société Arjowiggins et obtenue par des étapes du procédé selon l'invention (sans couche électro-conductrice),
- 3384 : Feuille Powercoat® avec un film aluminium de 12 µm intercalé entre le papier et la couche de base (épaisseur 240 µm)
- GD 28.09.12 / 1 : Echantillon témoin avec un mélange Cénibra/pacifico raffiné à 52°SR (épaisseur 193 µm)
- GD 28.09.12 / 2 : Echantillon avec un mélange Cénibra/pacifico raffiné à 52°SR et dopé avec 30 % de BN (épaisseur 193 µm)
- GD 31.08.12 /1 : Echantillon témoin avec un mélange Cénibra/pacifico raffiné à 40°SR (épaisseur 229 µm)
- GD 31.08.12 /4 : Echantillon avec un mélange Cénibra/pacifico raffiné à 40°SR dopé avec 20 % de fibres de Carbone (épaisseur 355 µm)
- GD 31.08.12 /5 : Echantillon avec un mélange Cénibra/pacifico raffiné à 40°SR dopé avec 60 % de noir de carbone (épaisseur 294 µm)

Dans le premier essai, on empile un nombre de feuilles suffisant pour avoir une épaisseur cumulée totale de 1 mm environ. On classe ensuite les feuilles en fonction des résultats de diffusivité.

| Echantillons | Nombre de feuilles | Epaisseur | Diffusivité [mm²/s] | Classement |
|---|---|---|---|---|
| GD310812-1 | 5 | 1,145 | 0,051 | 4 |
| GD310812-4 | 3 | 1,065 | 0,082 | 1 |
| GD310812-5 | 4 | 1,176 | 0,057 | 3 |
| 3382 | 5 | 1,150 | 0,040 | 7 |
| 3384 | 5 | 1,200 | 0,042 | 5 |
| GD280912-1 | 7 | 1,001 | 0,042 | 5 |
| GD280912-2 | 6 | 1,158 | 0,059 | 2 |

Dans le second essai, les empilements contiennent à chaque fois sept feuilles (donc le même nombre de lames d'air). Les épaisseurs des paquets de feuilles sont donc différentes.

| Echantillons | Nombre de feuilles | Epaisseur | Diffusivité [mm²/s] | Classement |
|---|---|---|---|---|
| GD310812-1 | 7 | 1,603 | 0,054 | 5 |
| GD310812-4 | 7 | 2,485 | 0,116 | 1 |
| GD310812-5 | 7 | 2,058 | 0,087 | 2 |
| 3382 | 7 | 1,610 | 0,046 | 6 |
| 3384 | 7 | 1,680 | 0,057 | 4 |
| GD280912-1 | 7 | 1,001 | 0,042 | 7 |
| GD280912-2 | 7 | 1,351 | 0,064 | 3 |

Dans le troisième et dernier essai, les empilements contiennent à chaque fois sept feuilles (donc le même nombre de lames d'air), les épaisseurs des paquets sont donc différentes. Les paquets de feuilles ont été compactés entre les doigts avant de les positionner dans l'appareil.

| Echantillons | Nombre de feuilles | Epaisseur | Diffusivité [mm²/s] | Classement |
|---|---|---|---|---|
| GD310812-1 | 7 | 1,603 | 0,057 | 4 |
| GD310812-4 | 7 | 2,485 | 0,134 | 1 |
| GD310812-5 | 7 | 2,058 | 0,085 | 2 |
| 3382 | 7 | 1,610 | 0,051 | 6 |
| 3384 | 7 | 1,680 | 0,056 | 5 |
| GD280912-1 | 7 | 1,001 | 0,045 | 7 |
| GD280912-2 | 7 | 1,351 | 0,085 | 2 |

Les feuilles GD310812-4, GD310812-5 et GD280912-2 ont les meilleurs résultats et les feuilles 3382 et GD280912-1 n'ont pas de bons résultats.

### Exemple 13 : Caractérisation des propriétés thermiques (diffusivité thermique) de feuilles de papier par thermographie infrarouge.

Le but des tests est d'évaluer les différences de propriétés thermiques de feuilles, et en particulier leur diffusivité thermique en surface (en XY) et en profondeur ou dans la masse (en Z). La thermographie infrarouge est l'étude du comportement thermique d'un composant en mesurant la température de surface et ses variations temporelles et spatiales.

Les premiers tests (Essai 1) consistent en une analyse temporelle. Les échantillons sont placés sur une plaque graphite et fixés à l'aide de brides. Une caméra est disposée à 400 mm de la plaque graphite. La distance lampes/plaque graphite est de 80mm. Deux lampes IR 650W sont espacées de 45 mm. L'ensemble est chauffé de façon périodique (T=4s, 6s ou 20s) avec une amplitude au niveau de la puissance des lampes de 0 à 50% ou 0 à 100%.

La stratégie adoptée a été de faire un classement des différents papiers en fonction de leurs performances (faible temps de réponse = meilleurs performances). Les papiers ayant des épaisseurs différentes, un autre classement a été réalisé en prenant en considération l'épaisseur des papiers : l'épaisseur au carré a été divisée par le temps de réponse, ce qui renseigne sur une grandeur proportionnelle à la diffusivité thermique (temps de réponse = longueur caractéristique au carré / diffusivité thermique).

Les seconds tests (Essai 2) consistent en une analyse en régime stabilisé. Les conditions sont les mêmes que celles lors de l'analyse temporelle. La consigne sur plaque graphite est fixée à 50°C.

Les derniers tests (Essai 3) consistent en une analyse en XY. Une plaque isolante perforée est posée (via une tige graphite) sur une lampe infrarouge (650W). Le trou est situé au-dessus d'un des deux filaments de la lampe. L'échantillon papier de dimensions suffisantes (75*75 mm) est posé sur deux tiges de graphite. La lampe est fixée à 10% de sa puissance maximale. Le traitement consiste à extraire les profils longitudinaux lorsque le pic de température de 60°C est atteint. Chaque échantillon a reçu le même traitement, le profil étant toujours au même endroit.

| **Echantillons** | **Essai 1, déphasage** | **Essai 1, déphasage** | **Essais 2** | |
|---|---|---|---|---|
| | **Pas de prise en compte épaisseur** | **Prise en compte épaisseur** | **Température stabilisée** | **Essai 3 XY** |
| | **Indice de classement** | **Indice de Classement** | **Classement** | **Classement** |
| **3382** | 3,75 | 4 | 6 | 6 |
| **3384** | 3 | 4 | 2 | 1 |
| **GD280912**-**1** | 5,5 | 6 | 3 | 7 |
| **GD280912-2** | 6,75 | 7 | 7 | 4 |
| **GD310812-1** | 3,25 | 4 | 4 | 5 |
| **GD310812-4** | 4 | 1,5 | 5 | 2 |
| **GD310812-5** | 1,75 | 1,5 | 1 | 3 |

| **Echantillons** | **Classement Général** |
|---|---|
| **GD310812-5** | 1,8 |
| **3384** | 2,5 |
| **GD310812-4** | 3,1 |
| **GD310812-1** | 4,1 |
| **3382** | 5 |
| **GD280912-1** | 5,4 |
| **DD280912-2** | 6,2 |

Le papier GD280912-1 semble un des moins bons dans les essais et le papier GD310812-4 semble un des meilleurs dans ces essais (1e /2e).

Une seconde série de feuilles a été préparée et comparée à un papier calque et à un film plastique PET (fdc = fibres de carbone).

| | | **Grammage (g/m²)** | **Epaisseur (µm)** | **Main** |
|---|---|---|---|---|
| VT_24.10.12.4 | 30% CaCO3 + calandrage | 210 | 173 | 0,8 |
| VT_24.10.12.6 | 30% CaCO3 + imprégnation PVA + calandrage | 220 | 203 | 0,92 |
| VT_24.10.12.7 | 30% CaCO3 | 215 | 256 | 1,2 |
| VT_24.10.12.8 | 20% fdc | 145 | 280 | 1,9 |
| VT_24.10.12.9 | 20% fdc + calandrage | 142 | 180 | 1,27 |
| VT_24.10.12.10 | 20% fdc + calandrage | 142 | 150 | 1,05 |
| VT_24.10.12.11 | 20% fdc + imprégnation PVA + calandrage | 183 | 261 | 1,43 |
| VT_25.10.12.1 | référence (fibres seules) + calandrage | 157 | 133 | 0,85 |
| VT_25.10.12.2 | référence (fibres seules) | 154 | 200 | 1,3 |
| Calque | / | 230 | 170 | 0,74 |
| PT125 (PET) | / | | 125 | |

Le papier PT125 semble un des moins bons dans les essais et le papier VT_24.10.12.9 semble un des meilleurs.
Les différents essais ont montré que le film d'aluminium permettait de fortement améliorer la diffusivité thermique dans en surface (x/y) de la feuille. Pour ce qui est de la diffusivité thermique en profondeur (z), deux paramètres ont confirmé leur influence très positive : le dopage au carbone (fibres ou charges) et le calandrage des papiers pour diminuer la quantité d'air.

Le meilleur résultat est donc de doper un papier (par exemple de 200µm d'épaisseur) avec du carbone, de le calandrer puis d'intercaler un film d'aluminium (par exemple de 12µm d'épaisseur) entre la couche de base (par exemple de 12µm d'épaisseur) de la feuille et le papier.

## Revendications

1. Procédé de fabrication d'une feuille comportant au moins une couche électro-conductrice, cette feuille comportant un substrat (24), en particulier en papier, dont au moins une face est recouverte au moins en partie d'une couche ou de plusieurs couches superposées dont la couche électro-conductrice précitée, le procédé comprenant les étapes consistant à:
a/ préparer ou apporter une structure multicouche (12) comprenant au moins, ou constituée par, un film plastique (14), un revêtement antiadhésif (16), et une couche de base (18), le revêtement antiadhésif étant intercalé entre une face du film plastique et la couche de base,
b/ encoller une face du substrat et/ou la face de la structure multicouche située du côté opposé au film plastique, et appliquer la face précitée du substrat contre la face précitée de la structure multicouche, de façon à contrecoller la structure multicouche et le substrat,
c/ retirer le film plastique et le revêtement antiadhésif de la couche de base, le procédé étant **caractérisé en ce que** la couche de base est recouverte d'une couche électro-conductrice par une étape supplémentaire consistant à:
d1/ déposer un film électro-conducteur sur la couche de base ; ou
d2/ imprimer la couche de base avec au moins une encre ayant des propriétés électriques, la couche de base étant une couche imprimable à base d'un liant dont le taux est supérieur à 15% en poids sec par rapport au poids total de matière sèche de cette couche, puis éventuellement soumettre la feuille imprimée à un traitement thermique de recuit de façon à former une couche d'encre électro-conductrice.

2. Procédé selon la revendication 1, **caractérisé en ce que** le liant de la couche de base imprimable comprend un liant principal et éventuellement un co-liant, le liant principal étant un latex synthétique tel qu'un copolymère styrène-butadiène (XSB) et/ou un copolymère styrène-acrylate (SA).

3. Procédé selon la revendication 2, **caractérisé en ce que** le co-liant est un promoteur d'adhérence à base d'un copolymère éthylène - acide acrylique (EAA).

4. Procédé selon l'une des revendications précédentes, **caractérisé en ce que** la couche de base imprimable est imprimée par jet d'encre, héliogravure, flexographie, sérigraphie ou offset.

5. Procédé selon l'une des revendications précédentes, **caractérisé en ce que** la couche de base imprimable comprend des pigments, qui ont par exemple un diamètre moyen inférieur ou égal à 2µm environ.

6. Procédé selon l'une des revendications précédentes, **caractérisé en ce que** la feuille comprend un film métallique et/ou une couche barrière à base de polyuréthane (PU), de polyalcool vinylique (PVA), de polychlorure de vinylidène (PVDC), de copolymère éthylène-acétate de vinyle (EVAC), de nanofibres de cellulose, ou de métal, cette couche barrière étant située entre le substrat et la couche de base.

7. Procédé selon l'une des revendications précédentes, **caractérisé en ce que** le substrat (24) est un papier calque, et **en ce que** la couche de base imprimable présente une transparence et a un taux de liant supérieur à 30% en poids sec par rapport au poids total de matière sèche de la couche de base.

8. Procédé selon l'une des revendications précédentes, **caractérisé en ce que** l'étape d2/ est répétée au moins une fois, chaque étape d2/ qui suit une étape d2/ étant séparée de cette étape par une étape intermédiaire de repos de la feuille, pendant laquelle la feuille est destinée à récupérer sensiblement sont taux d'humidité initial.

9. Procédé selon l'une des revendications précédentes, **caractérisé en ce que** l'étape d2/ est précédée d'une étape consistant à soumettre la couche de base à un traitement plasma.

10. Procédé selon l'une des revendications précédentes, **caractérisé en ce que** :
(i) dans la structure multicouche préparée à l'étape a), la couche de base s'étend sur une surface inférieure à celle de la face précitée du film plastique, et/ou
(ii) la structure multicouche et le substrat sont contrecollés à l'étape b) sur une surface inférieure à celle de la face précitée de la feuille, et/ou
(iii) le film plastique retiré à l'étape c) a au moins une dimension parmi sa longueur et sa largeur qui est inférieure à la ou les dimensions correspondantes de la face précitée de la feuille, et/ou
(iv) la feuille obtenue à l'étape c) est découpée puis au moins un morceau découpé de cette feuille est collé sur le substrat d'une autre feuille,
de façon à ce que la feuille comporte au moins une face ayant au moins une zone de plus grand lissé que le reste de cette face, cette zone comportant une couche externe lisse qui est formée par la couche de base et qui s'étend sur le substrat de la feuille sur une surface inférieure à celle de ladite face.

11. Procédé selon la revendication 10, **caractérisé en ce que** l'application de la structure multicouche (12) sur le substrat (24) est réalisée à l'étape b) au moyen d'une presse embosseuse qui est destinée à appliquer une pression dans la zone précitée, ou au moyen d'une presse de dorure à chaud qui permet de ramollir la colle utilisée à l'étape b), qui est du type thermosensible.

12. Procédé selon l'une des revendications 10 ou 11, **caractérisé en ce qu'**il comprend, avant l'étape c), une étape d'impression de la face de la structure multicouche située du côté opposé au film plastique avec des encres électro-conductrices, ou de dépôt d'un revêtement électro-conducteur sur cette face.

13. Procédé selon l'une des revendications 10 à 12, **caractérisé en ce que**, pendant l'étape a), le revêtement antiadhésif déposé sur le film plastique est imprimé avec des encres électro-conductrices ou est recouvert d'un revêtement électro-conducteur.

14. Procédé de fabrication d'un produit électro-conducteur comprenant la réalisation, au moyen d'une feuille électro-conductrice obtenue par un procédé selon l'une des revendications précédentes, d'au moins une résistance, une capacité, un transistor, une puce RFID, un circuit logique, un interrupteur à membrane (SWITCH), une cellule photovoltaïque, une batterie, un moyen de collecte d'énergie, un système de rétroéclairage, un moyen d'affichage ou d'éclairage électroluminescent tel qu'une diode électroluminescente inorganique ou organique (OLED), un clavier à membrane, un capteur, ou toute combinaison de ces composants, notamment par mise en oeuvre d'une étape d'impression de la couche de base et/ou d'une étape de retrait par photolithographie ou par ablation laser de certaines zones prédéterminées de la couche électro-conductrice.

## Patentansprüche

1. Herstellungsverfahren eines Blattes, das wenigstens eine elektrisch leitende Schicht umfasst, wobei dieses Blatt ein Substrat (24), insbesondere aus Papier, umfasst, von dem wenigstens eine Seite wenigstens teilweise mit einer Schicht oder mehreren überlagerten Schichten abgedeckt ist, darunter die vorgenannte elektrisch-leitende Schicht, wobei das Verfahren aus den Schritten besteht:
a) Vorbereiten oder Einbringen einer mehrschichtigen Struktur (12), umfassend oder gebildet wenigstens aus eine(r) Plastikfolie (14), eine(r) Antihaftbeschichtung (16) und einer Basisschicht (18), wobei die Antihaftbeschichtung zwischen einer Seite der Plastikfolie und der Basisschicht zwischengeschaltet ist,
b) Verkleben einer Seite des Substrats und / oder der Seite der mehrschichtigen Struktur, die sich auf der zur Plastikfolie entgegengesetzten Seite befindet, und Anwenden der vorgenannten Seite des Substrats gegen die vorgenannte Seite der mehrschichtigen Struktur derart, dass die mehrschichtige Struktur und das Substrat gegeneinander verklebt werden,
c) Entfernen der Plastikfolie und der Antihaftbeschichtung von der Basisschicht, wobei das Verfahren **dadurch gekennzeichnet ist, dass** die Basisschicht mit einer elektrisch leitenden Schicht durch einen zusätzlichen Schritt abgedeckt ist, der besteht aus:
d1) Aufbringen einer elektrisch leitenden Folie auf der Basisschicht; oder
d2) Bedrucken der Basisschicht mit wenigstens einer Druckfarbe, die elektrische Eigenschaften hat, wobei die Basisschicht eine bedruckbare Schicht basierend auf einem Bindemittel ist, dessen Gehalt höher ist als 15 % Trockengewicht im Verhältnis zum Gesamtgewicht der Trockenmasse dieser Schicht, dann eventuell die bedruckte Folie einer thermischen Glühbehandlung derart unterziehen, dass eine elektrisch leitende Druckfarbenschicht gebildet wird.

2. Verfahren gemäß Anspruch 1, **dadurch gekennzeichnet, dass** das Bindemittel der bedruckbaren Basisschicht ein Hauptbindemittel und eventuell ein Ko-Bindemittel umfasst, wobei das Hauptbindemittel ein synthetischer Latex ist, wie z. B. ein Styrol-Butadien-Mischpolymer (XSB) und / oder ein Styrol-Acrylat-Kopolymer (SA).

3. Verfahren gemäß Anspruch 2, **dadurch gekennzeichnet, dass** das Ko-Bindemittel ein Anhaftpromoter basierend auf einem Ethylen-Ko-Polymer / Acrylsäure (EAA) ist.

4. Verfahren gemäß einem der voranstehenden Ansprüche, **dadurch gekennzeichnet, dass** die bedruckbare Basisschicht per Tintenstrahl, Rotationstiefdruck, Flexodruck, Siebdruck oder Offsetdruck bedruckt wird.

5. Verfahren gemäß einem der voranstehenden Ansprüche, **dadurch gekennzeichnet, dass** die bedruckbare Basisschicht Pigmente umfasst, die z. B. einen durchschnittlichen Durchmesser von kleiner als oder gleich ungefähr 2 µm hat.

6. Verfahren gemäß einem der voranstehenden Ansprüche, **dadurch gekennzeichnet, dass** das Blatt eine Metallfolie und / oder eine Barriereschicht basierend auf Polyurethan (PU), Vinylpolyalkohol (PVA), Polvinylidenchlorid (PVDC), Ethylen-Vinylacetat-Kopolymer-(EVAC), Zellulose-Nanofasern oder Metall umfasst, wobei diese Schicht zwischen dem Substrat und der Basisschicht angeordnet ist.

7. Verfahren gemäß einem der voranstehenden Ansprüche, **dadurch gekennzeichnet, dass** das Substrat (24) ein Pauspapier ist und dass die bedruckbare Basisschicht eine Transparenz aufweist und einen Bindemittelgehalt von mehr als 30 % Trockengewicht im Verhältnis zum Gesamtgewicht der Trockenmasse der Basisschicht hat.

8. Verfahren gemäß einem der voranstehenden Ansprüche, **dadurch gekennzeichnet, dass** der Schritt d2) wenigstens einmal wiederholt wird, wobei jeder Schritt d2), der auf einen Schritt d) folgt, von diesem Schritt durch einen Ruhe-2wischenschritt des Blattes getrennt ist, während dessen das Blatt dazu bestimmt ist, seinen ursprünglichen Feuchtigkeitsgehalt deutlich zurückzugewinnen.

9. Verfahren gemäß einem der voranstehenden Ansprüche **dadurch gekennzeichnet, dass** dem Schritt d2) ein Schritt vorausgeht, der darin besteht, die Basisschicht einer Plasmabehandlung zu unterziehen.

10. Verfahren gemäß einem der voranstehenden Ansprüche, **dadurch gekennzeichnet, dass**:
(i) in der in Schritt a) vorbereiteten mehrschichtigen Struktur die Basisschicht sich über eine Fläche erstreckt, die geringer ist als die der vorgenannten Seite der Plastikfolie und / oder
(ii) die mehrschichtige Struktur und das Substrat in Schritt b) auf einer Fläche gegeneinander verklebt sind, die geringer ist als die der vorgenannten Seite des Blattes und / oder
(iii) die in Schritt c) entfernte Plastikfolie in ihrer Länge und ihrer Breite wenigstens eine Abmessung hat, die geringer ist als die entsprechende (n) Abmessung(en) der vorgenannten Seite des Blattes und / oder
(iv) das in Schritt c) erhaltene Blatt zugeschnitten ist und dann wenigstens ein Stück dieses Blattes auf das Substrat eines anderen Blattes derart geklebt ist, dass das Blatt wenigstens eine Seite umfasst, die wenigstens einen Bereich einer größeren Glätte hat als der Rest dieser Seite, wobei dieser Bereich eine externe glatte Schicht umfasst, die durch die Basisschicht geformt ist und die sich auf dem Substrat des Blattes auf einer Fläche erstreckt, die geringer ist als die der genannten Seite.

11. Verfahren gemäß Anspruch 10, **dadurch gekennzeichnet, dass** die Anwendung der mehrschichtigen Struktur (12) auf dem Substrat (24) in dem Schritt b) mittels einer Prägepresse, die zur Anwendung eines Drucks in dem vorgenannten Bereich bestimmt ist, oder mittels einer Goldprägepresse, die das Aufweichen des in Schritt b) verwendeten Klebstoffs erlaubt, der vom Typ thermosensibel ist, realisiert ist.

12. Verfahren gemäß einem der Ansprüche 10 oder 11, **dadurch gekennzeichnet, dass** es vor dem Schritt c) einen Druckschritt der Seite der mehrschichtigen Struktur, die sich auf der der Plastikfolie entgegengesetzten Seite befindet, mit elektrisch leitenden Druckfarben oder der Aufbringung einer elektrisch leitenden Beschichtung auf dieser Seite umfasst.

13. Verfahren gemäß einem der Ansprüche 10 bis 12, **dadurch gekennzeichnet, dass** während des Schritts a) die auf der Plastikfolie aufgebrachte Antihaftbeschichtung mit elektrisch leitenden Druckfarben bedruckt oder mit einer elektrisch leitenden Beschichtung abgedeckt wird.

14. Herstellungsverfahren eines elektrisch leitenden Produkts, umfassend die Realisierung wenigstens eines Widerstandes, einer Kapazität, eines Transistors, eines Chips RFID, eines logischen Schaltkreises, eines Membranschalters (SWITCH), einer photovoltaischen Zelle, einer Batterie, eines Energieauffangmittels, eines Hintergrundbeleuchtungssystems, eines Anzeige- oder Elektrolumineszenz-Beleuchtungsmittels, wie z. B. einer anorganischen oder organischen Elektrolumineszenz-Diode (OLED), einer Membrantastatur, eines Sensors oder jeder Kombination dieser Bauteile mittels eines durch ein Verfahren gemäß einem der voranstehenden Ansprüche erhaltenen elektrisch leitenden Blattes, insbesondere durch die Umsetzung eines Druckschritts der Basisschicht und / oder eines Abnahmeschrittes per Fotolitografie oder per Laserablation von bestimmten, vorbestimmten Bereichen der elektrisch leitenden Schicht.

## Claims

1. Method for producing a sheet comprising at least one electroconductive layer, said sheet comprising a substrate (24), in particular made of paper, of which at least one side is covered at least partially with a layer or several superimposed layers including the aforementioned electroconductive layer, the method comprising the steps of:
a/ preparing or providing a multi-layer structure (12) comprising at least, or comprised of, a plastic film (14), an anti-adhesive coating (16), and a base layer (18), the anti-adhesive coating being sandwiched between a side of the plastic film and the base layer,
b/ applying adhesive to a side of the substrate and/or the side of the multi-layer structure located opposite to the plastic film, and applying said side of the substrate against said side of the multi-layer structure, in such a way as to cross-laminate the multi-layer structure and the substrate,
c/ removing the plastic film and the anti-adhesive coating from the base layer, the method being **characterised in that** the base layer is covered with an electroconductive layer by an additional step consisting of:
d1/ depositing an electroconductive film on the base layer; or
d2/ printing the base layer with at least one ink having electrical properties, with the base layer being a printable layer based on a binder whose content is greater than 15% by dry weight relative to the total weight of dry matter of this layer, then optionally subjecting the printed sheet to an annealing heat treatment in such a way as to form a layer of electroconductive ink.

2. Method according to claim 1, **characterised in that** the binder of the printable base layer comprises a main binder and optionally a co-binder, with the main binder being a synthetic latex such as a styrenebutadiene copolymer (XSB) and/or a styrene-acrylate copolymer (SA).

3. Method according to claim 2, **characterised in that** the co-binder is an adhesion promoter based on an ethylene acrylic acid (EAA) copolymer.

4. Method according to one of the preceding claims, **characterised in that** the printable base layer is printed by ink jet, rotogravure, flexography, screen printing or offset.

5. Method according to one of the preceding claims, **characterised in that** the printable base layer comprises pigments, which have for example an average diameter less than or equal to about 2 µm.

6. Method according to one of the preceding claims, **characterised in that** the sheet comprises a metal film and/or a barrier layer based on polyurethane (PU), polyvinyl alcohol (PVA), polyvinylidene chloride (PVDC), ethylene vinyl acetate copolymer (EVAC), cellulose nanofibres, or metal, said barrier layer being located between the substrate and the base layer.

7. Method according to one of the preceding claims, **characterised in that** the substrate (24) is a tracing paper, and **in that** the printable base layer has a transparency and a binder content of greater than 30% by dry weight relative to the total weight of dry matter of the base layer.

8. Method according to one of the preceding claims, **characterised in that** the step d2/ is repeated at least once, each step d2/ following a step d2/ being separated from one another by an intermediary step of letting the sheet rest, during which the sheet is intended to substantially recover its initial humidity level.

9. Method according to one of the preceding claims, **characterised in that** the step d2/ is preceded by a step consisting of subjecting the base layer to a plasma treatment.

10. Method according to one of the preceding claims, **characterised in that**:
(i) in the multi-layer structure prepared in step a), the base layer extends over a surface area smaller than that of the aforementioned side of the plastic film, and/or
(ii) the multi-layer structure and the substrate are cross-laminated in step b) on a surface area smaller than that of the aforementioned side of the sheet, and/or
(iii) the plastic film removed in step c) has at least one of its length and width which is smaller than the corresponding dimension or dimensions of the aforementioned side of the sheet, and/or
(iv) the sheet obtained in step c) is cut and then at least one cut piece from this sheet is glued onto the substrate of another sheet,
in such a way that the sheet comprises at least one side having at least one zone of greater smoothness than the rest of this side, said zone comprising a smooth external layer which is formed by the base layer and which extends over the substrate of the sheet on a surface area smaller than that of said side.

11. Method according to claim 10, **characterised in that** the application of the multi-layer structure (12) onto the substrate (24) is carried out in step b) by means of a stamp press which is intended to apply a pressure in the aforementioned zone, or by means of a hot foil stamp press which makes it possible to soften the adhesive used in step b), which is of the heat-sensitive type.

12. Method according to one of claims 10 or 11, **characterised in that** it comprises, before the step c), a step of printing the side of the multi-layer structure located opposite to the plastic film with electroconductive inks, or of depositing an electroconductive coating on said side.

13. Method according to one of claims 10 to 12, **characterised in that**, during the step a), the anti-adhesive coating deposited on the plastic film is printed with electroconductive inks or is covered with an electroconductive coating.

14. Method for producing an electroconductive product comprising producing, by means of an electroconductive sheet obtained by a method according to one of the preceding claims, at least one of a resistor, a capacitor, a transistor, an RFID chip, a logic circuit, a membrane switch (SWITCH), a photovoltaic cell, a battery, a means for collecting energy, a backlighting system, a means of solid-state lighting or display such as an organic or inorganic light-emitting diode (OLED), a membrane keyboard, a sensor, or any combination of these components, in particular through the implementation of a step of printing of the base layer and/or of a step of removing certain predetermined zones of the electroconductive layer via photolithography or laser ablation.
